(19) **Europäisches Patentamt / European Patent Office / Office européen des brevets**

(11) **EP 4 300 758 B1**

(12) **EUROPEAN PATENT SPECIFICATION**

(45) Date of publication and mention
of the grant of the patent:
**25.03.2026 Bulletin 2026/13**

(21) Application number: **22759152.6**

(22) Date of filing: **17.01.2022**

(51) International Patent Classification (IPC):
*H02J 7/00* (2026.01)    *G01R 31/367* (2019.01)
*G01R 31/3842* (2019.01)    *G01R 31/388* (2019.01)
*G01R 31/392* (2019.01)    *H01M 10/42* (2006.01)
*H01M 10/48* (2006.01)    *H02J 13/00* (2026.01)
*B60L 58/10* (2019.01)    *B60L 58/16* (2019.01)

(52) Cooperative Patent Classification (CPC):
**H02J 7/82; B60L 58/10; B60L 58/16; G01R 31/392;
H01M 10/42; H01M 10/48; H02J 7/84;
H02J 13/1331;** H02J 1/109; H02J 2105/37;
Y02E 60/10

(86) International application number:
**PCT/JP2022/001289**

(87) International publication number:
**WO 2022/181109 (01.09.2022 Gazette 2022/35)**

(54) **BATTERY MANAGEMENT SYSTEM**

BATTERIEVERWALTUNGSSYSTEM

SYSTÈME DE GESTION DE BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.02.2021 JP 2021029386**

(43) Date of publication of application:
**03.01.2024 Bulletin 2024/01**

(73) Proprietor: **DENSO CORPORATION
Kariya-city, Aichi 448-8661 (JP)**

(72) Inventors:
• **YAMAMOTO, Hiroyoshi
  Kariya-city, Aichi 448-8661 (JP)**
• **YOSHIDA, Shuhei
  Kariya-city, Aichi 448-8661 (JP)**

• **SHIMONISHI, Yuta
  Kariya-city, Aichi 448-8661 (JP)**
• **NAGASHIMA, Sho
  Kariya-city, Aichi 448-8661 (JP)**
• **TAKIZAWA, Kazuya
  Kariya-city, Aichi 448-8661 (JP)**

(74) Representative: **TBK
Bavariaring 4-6
80336 München (DE)**

(56) References cited:
WO-A1-2013/038458    WO-A1-2020/044597
WO-A1-2021/014899    JP-A- 2015 059 924
JP-A- 2017 069 011    JP-A- 2020 054 214
US-A1- 2014 320 144    US-A1- 2020 014 238
US-B1- 9 056 556

EP 4 300 758 B1

**Description**

CROSS REFERENCE TO RELATED APPLICATIONS

This present application is based on Japanese Patent Application No. 2021-029386 filed on February 26, 2021.

TECHNICAL FIELD

The present disclosure relates to a battery management system that manages secondary batteries respectively mounted on use devices.

BACKGROUND

Currently, secondary batteries are used in various fields, and an electric vehicle is known as a use device on which the secondary battery is mounted. In an electric vehicle, a decrease in cruising distance due to deterioration of a secondary battery is an issue. Therefore, it is preferable to manage a combination of the secondary battery and the electric vehicle, which is a use device, in consideration of deterioration of the secondary battery. As a technique related to such a management of secondary battery, a technique described in Patent Document 1 is known.

The management system of Patent Document 1 is configured to assign a vehicle equipped with a secondary battery having a larger deterioration prediction value to a use environment in which a deterioration tendency of the secondary battery is small (that is, an environment in which the battery load is predicted to be small). According to the technique of Patent Document 1, variation in deterioration of the secondary battery among all of the managed vehicles is suppressed, such that the life of the secondary battery is extended and the vehicle management is made efficient.

In addition, patent application US 2014/320144 A1 discloses a storage battery relocation assistance apparatus comprising: a collection section that collects battery information representing a state of a plurality of storage batteries used in a plurality of facilities; a battery information storing section that stores the battery information collected by the collection section; and a deterioration prediction section that predicts deterioration of the plurality of storage batteries when the plurality of storage batteries are relocated and used among the plurality of facilities, based on the battery information stored in the battery information storing section.

PRIOR ART LITERATURE

PATENT LITERATURE

Patent Document 1: JP 5259443 B

SUMMARY

The deterioration prediction value in Patent Document 1 indicates a prediction value at a predetermined target time point while maintaining the allocation of the secondary battery to the vehicle based on the deterioration tendency of the use environment. That is, in Patent Document 1, when the allocation between the vehicle and the secondary battery is changed, only the deterioration prediction in the state before the change can be applied, and the changed deterioration prediction in the state where the allocation between the vehicle and the secondary battery is not reflected.

In addition, it is known that, in predicting the deterioration of the secondary battery, the influence of the past usage history has a large influence on the progress of the deterioration due to the subsequent use. In Patent Document 1, since the influence of the past usage history cannot be taken into consideration, there is room for improvement in the accuracy of predicting the deterioration of each secondary battery.

In view of the above, an object of the present disclosure is to provide a vehicle management system capable of appropriately managing progress of deterioration in secondary batteries on the basis of a usage history of the secondary batteries and a battery load to be generated in the secondary batteries in the future.

According to the present invention, battery management systems as defined in claims 1 and 3 are provided. Further advantageous aspects of the present invention are defined in the dependent claims.

According to the present disclosure, a battery management system manages secondary batteries used in a use device. The battery management system includes a usage history acquisition unit, a deterioration estimation unit, a battery load acquisition unit, a deterioration change degree identification unit, and a battery management unit.

The usage history acquisition unit acquires usage history information indicating a usage history of the secondary battery in a period in which the secondary battery is mounted on the use device. The deterioration estimation unit estimates a current deterioration state of the secondary battery and a deterioration factor causing the deterioration state based on the usage history information acquired by the usage history acquisition unit.

The battery load acquisition unit acquires battery load information indicating a battery load that is calculated using a future use mode of the secondary battery in the use device and is estimated to be applied to the secondary battery when a predetermined scheduled use period elapses in a future.

The deterioration change degree identification unit identifies a deterioration change degree indicating a change in the deterioration state of the secondary battery at a time point when the scheduled use period elapses, using the current deterioration state and the deterioration factor estimated by the deterioration estimation unit and the battery load information of the secondary battery acquired by the battery load acquisition unit.

The battery management unit uses the deterioration change degree of the secondary battery identified by the deterioration change degree identification unit to associate the secondary batteries with future use modes such that an evaluation value indicating the degree of deterioration of the secondary batteries in use devices becomes a minimum value.

Accordingly, since the deterioration change degree is identified using the current deterioration state and the deterioration factor of the secondary battery and the battery load information calculated using the future use mode, it is possible to accurately specify the deterioration change degree of the secondary battery at the time when the scheduled use period elapses.

Then, according to the battery management system, since the future use modes are associated with the secondary batteries using the deterioration change degree so that the evaluation value becomes the minimum value, it is possible to associate the secondary batteries with future use modes in an appropriate manner corresponding to the deterioration state, the deterioration factor, and the battery load information of the secondary battery.

BRIEF DESCRIPTION OF THE DRAWINGS

The foregoing and other objects, features, and advantages of the present disclosure will become more apparent from the following detailed description with reference to the accompanying drawings. In the accompanying drawings:

FIG. 1 is a schematic configuration diagram of a battery management system according to a first embodiment;
FIG. 2 is a configuration diagram of a vehicle in the battery management system of the first embodiment;
FIG. 3 is a configuration diagram of a management server in the battery management system of the first embodiment;
FIG. 4 is a flowchart of a battery management process of the first embodiment;
FIG. 5 is a flowchart related to calculation of a battery state in the first embodiment;
FIG. 6 is an explanatory diagram related to interpolation of a battery load history in the first embodiment;
FIG. 7 is an explanatory diagram schematically showing a relationship between an open circuit voltage and a closed circuit voltage of a secondary battery before deterioration and the SOC;
FIG. 8 is an explanatory diagram schematically illustrating a relationship between an open circuit voltage and a closed circuit voltage of a secondary battery after deterioration and the SOC;
FIG. 9 is an explanatory diagram related to an influence of a degradation mode on future progress of degradation;
FIG. 10 is an explanatory diagram related to extraction of a recommended pattern in the first embodiment;
FIG. 11 is an explanatory diagram related to extraction of a recommended pattern in a second embodiment;
FIG. 12 is an explanatory diagram related to extraction of a recommended pattern in a third embodiment; and
FIG. 13 is an explanatory diagram related to extraction of a recommended pattern in a fourth embodiment.

DESCRIPTION OF EMBODIMENTS

Embodiments of the present disclosure will be described hereafter referring to drawings. In the embodiments, a part that corresponds to a matter described in a preceding embodiment may be assigned with the same reference numeral, and redundant explanation for the part may be omitted. When only a part of a configuration is described in an embodiment, another preceding embodiment may be applied to the other parts of the configuration. The parts may be combined even if it is not explicitly described that the parts can be combined. The embodiments may be partially combined even if it is not explicitly described that the embodiments can be combined, provided there is no harm in the combination.

First Embodiment

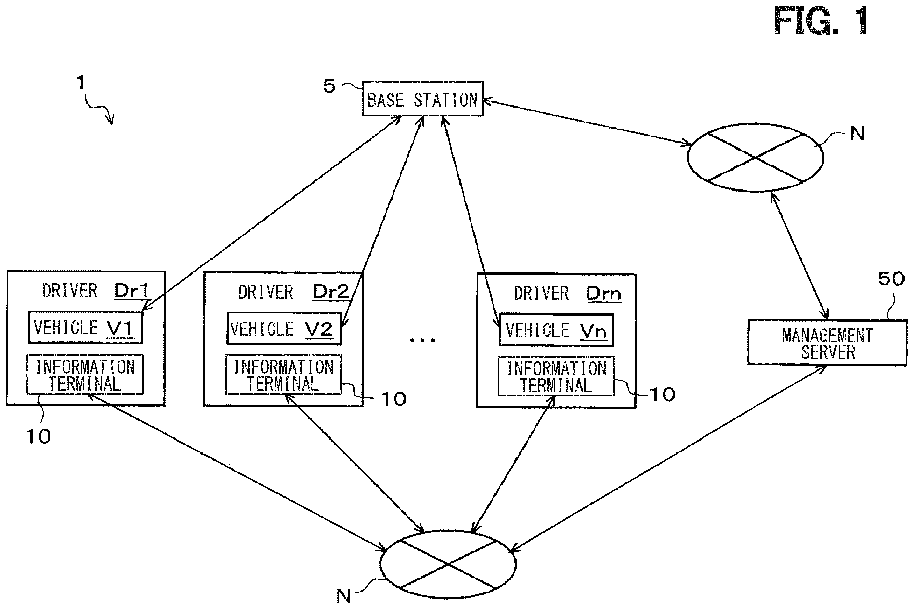

A first embodiment of the present disclosure will be described with reference to FIG. 1 to FIG. 10. In the present embodiment, the battery management system 1 according to the present disclosure is for a category in which a transportation company or the like allocates an electric vehicle (hereinafter, referred to a vehicle V) equipped with a secondary battery 25 to each driver Dr and operates the electric vehicle.

The battery management system 1 is configured to determine the association of the driver Dr with each secondary battery 25 in consideration of the future usage mode of the vehicle V (secondary battery 25) in addition to the deterioration degree and the deterioration factor of the secondary battery 25 in each vehicle V. As a result, the battery management system 1 can manage the secondary battery 25 (vehicle V) in a manner that is most beneficial to the operator (such as a transportation company) of the battery management system 1.

In the following description, when the battery management system 1 individually indicates drivers Dr, numbers (1 to n) are added to the reference numerals Dr of the drivers Dr. Similarly, when vehicles in the battery management system 1 are individually indicated, numbers (1 to n) are added to the reference numerals V of the vehicles V.

As illustrated in FIG. 1, the battery management system 1 includes the vehicles V. The vehicle V is an electric vehicle in which the secondary battery 25 is mounted to obtain driving force for traveling from a motor generator 20.

A battery load history, which is usage history information of the secondary battery 25 in the vehicle V, is transmitted from each vehicle V to a predetermined base station 5. The battery load history includes the battery temperature T, the current value I, the state of charge (SOC), and the like of the secondary battery 25 mounted on the vehicle V. The battery load history is transmitted from the base station 5 to the management server 50 in the data center via the network N using the Internet or a dedicated line.

The vehicle V only needs to be a vehicle including the motor generator 20, such as a hybrid vehicle that obtains driving force for traveling from the motor generator 20 and an internal combustion engine (engine).

An operation route along which the vehicle V travels is associated with the driver Dr to whom the vehicle V is assigned. For example, in the case of a carrier, a predetermined operation route is associated with the driver Dr, and the driver Dr travels on the operation route with the assigned vehicle V to perform a transport operation.

The information terminal 10 is allocated to each driver Dr. The information terminal 10 is configured by a tablet terminal, a smartphone, or the like, and is used for inputting a work status, a vacation schedule, and the like of each driver Dr.

The working status and the like of the driver Dr input to the information terminal 10 are related to the future input/output status of the secondary battery 25 mounted on the vehicle V, and thus constitute a predicted battery load corresponding to the battery load information. When the predicted battery load is transmitted from each information terminal 10, the predicted battery load is stored in the driver database 55 of the management server 50 via the network N.

The management server 50 estimates the degree of deterioration of the secondary battery 25 mounted on the vehicle V and the configuration of the deterioration factor using the battery load history transmitted from each vehicle V. Then, by using the estimated deterioration degree and the deterioration factor of each secondary battery 25 and the predicted battery load, a deterioration change degree is obtained, which is a change amount of the future deterioration degree of the secondary battery 25 when used at the predicted battery load.

The battery management system 1 evaluates a combination of the secondary battery 25 of each vehicle V and the predicted battery load derived from each driver Dr according to an evaluation value specified by using the deterioration change degree, and determines a recommended pattern of association between the vehicle V and the driver Dr.

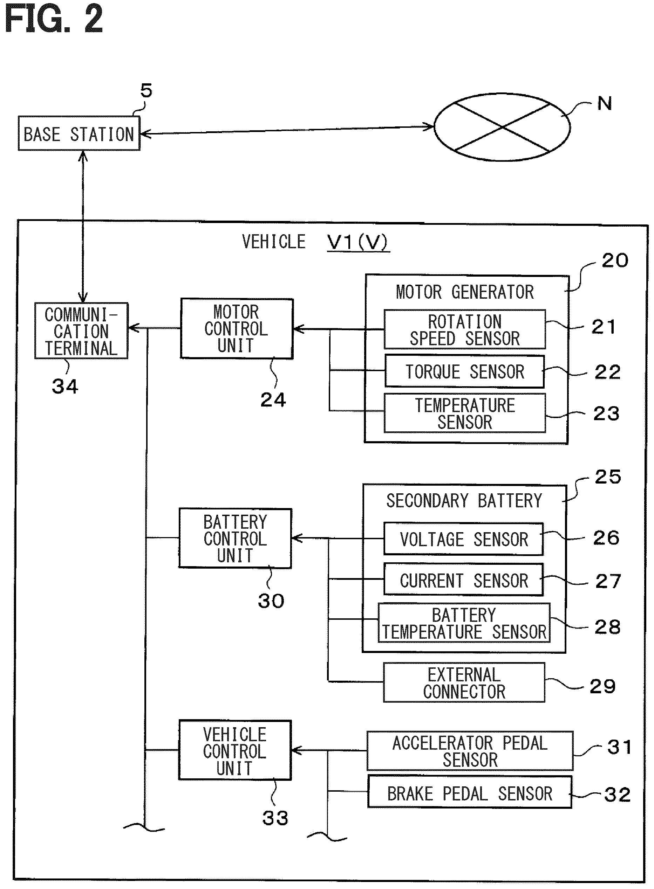

First, the configuration of the vehicle V in the battery management system 1 will be described with reference to FIG. 2. In FIG. 2, the configuration of the vehicle V1 is illustrated as an example of the vehicle V, but the other vehicles V (such as vehicle V2, vehicle V3, etc.) have the same basic configuration.

As illustrated in FIG. 2, the motor generator 20 is mounted on the vehicle V as a drive source. A rotation speed sensor 21 that detects a motor rotational speed, a torque sensor 22 that detects a motor torque, a temperature sensor 23 that detects a motor temperature, and the like are attached to the motor generator 20.

The vehicle V is provided with a motor control unit 24 that controls a driving state of the motor generator 20. Vehicle information such as a motor rotational speed, a motor torque, and a motor temperature is input to the motor control unit 24 from the rotation speed sensor 21, the torque sensor 22, and the temperature sensor 23.

As described above, the secondary battery 25 is mounted on the vehicle V. The secondary battery 25 supplies electric power to the motor generator 20 and also supplies electric power to other in-vehicle devices. The secondary battery 25 includes battery cells connected in series with each other. The secondary battery 25 is configured by, for example, a battery pack including modules in which battery cells are arranged in a row. The battery cell is, for example, a lithium ion secondary battery.

The negative electrode of the secondary battery 25 is made of, for example, a negative electrode active material capable of occluding and releasing lithium ions such as graphite. The positive electrode of the secondary battery 25 can be, for example, a ternary electrode containing Ni, Mn, and Co such as $LiNi_{1/3}Co_{1/3}Mn_{1/3}O_2$. As the electrode, an electrode made of a composite material may be adopted. Battery cells may be connected in parallel to form a cell block, and the cell blocks may be connected in series to form the secondary battery 25.

A voltage sensor 26, a current sensor 27, and a battery temperature sensor 28 are connected to the secondary battery 25. The voltage sensor 26 detects a voltage value of the secondary battery 25. The current sensor 27 detects the current value I of the secondary battery 25. The battery temperature sensor 28 detects the battery temperature T of the secondary battery 25.

As shown in FIG. 2, the secondary battery 25 is provided with an external connector 29. The external connector 29 is connectable to a power system outside the vehicle V. Therefore, the secondary battery 25 can supply the power of the secondary battery 25 to an external power system, and can receive power supply from an external power system to the secondary battery 25.

The vehicle V is provided with a battery control unit 30. Information such as the voltage value, the current value, and the battery temperature T from the voltage sensor 26, the current sensor 27, and the battery temperature sensor 28 described above is input to the battery control unit 30. These pieces of information form a battery load history described later. Therefore, the battery control unit 30 manages the use history and the like of the secondary battery 25.

The battery control unit 30 controls a charge/discharge state of the secondary battery 25. That is, the battery control unit 30 forms a so-called battery management unit.

Further, the vehicle V is provided with a vehicle control unit 33. The vehicle control unit 33 integrally controls the entire vehicle V. An accelerator pedal sensor 31, a brake pedal sensor 32, and the like are connected to the vehicle control unit 33. Therefore, vehicle information such as an operation status of an accelerator pedal and a brake pedal is input to the vehicle control unit 33.

The information input to the motor control unit 24, the battery control unit 30, and the vehicle control unit 33 is output from the communication terminal 34 mounted on the vehicle control unit 33 to the management server 50 via the base station 5 and the network N.

The communication terminal 34 has a function of receiving radio waves from a GPS satellite (not illustrated), and can determine position information of the vehicle V using a global positioning system (GPS). Position information, speed information, and the like obtained from the GPS are also transmitted as information accompanying the battery load history from the communication terminal 34 to the management server 50 via the base station 5 and the network N.

While a mobile phone, a wireless LAN, or the like can be used for wireless communication between the communication terminal 34 and the base station 5, when a charging cable (not illustrated) is connected to the external connector 29 of the vehicle V, for example, various types of information may be transmitted by wired communication. In addition, the timing at which various types of information such as the battery load history are transmitted from the vehicle V to the management server 50 may be transmission in real time or may be collective transmission at a predetermined timing.

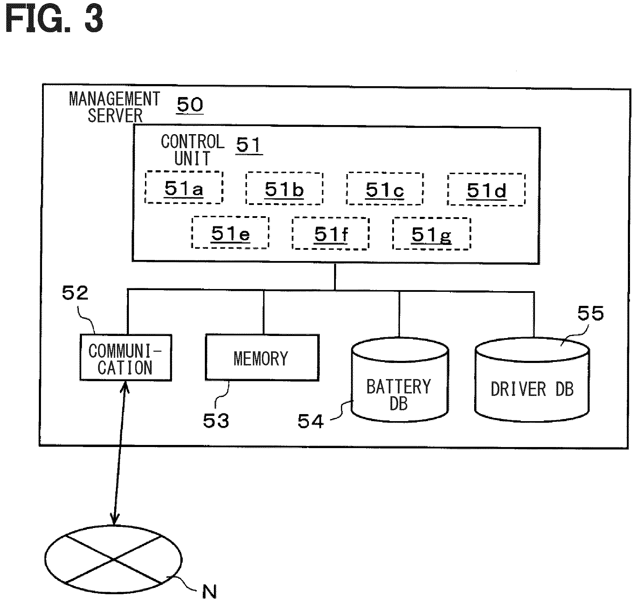

Next, a configuration of the management server 50 in the battery management system 1 will be described with reference to FIG. 3. As illustrated in FIG. 3, the management server 50 includes a general server computer having a control unit 51, a communication unit 52, a storage device 53, and the like. The management server 50 uses the deterioration state of the secondary battery 25 and the predicted battery load based on the future use plan to appropriately associate the vehicles V on which the secondary batteries 25 are mounted with the driver Dr who drives the vehicle V.

The control unit 51 is configured by a known microcomputer including a CPU, a ROM, a RAM, and the like, and peripheral circuits thereof. The CPU of the control unit 51 executes a control program stored in the ROM to implement each functional unit in the battery management system 1. The communication unit 52 enables bidirectional communication of data with each vehicle V and each information terminal 10 via the network N. The storage device 53 is a memory that temporarily stores target data and temporarily stores a calculation result when the communication unit 52 transmits and receives data.

In addition, the management server 50 has the battery database 54 and the driver database 55. The battery database 54 stores the battery load history transmitted from each vehicle V. The battery database 54 includes an element degradation state and a battery state calculated by battery management processing to be described later, in addition to information such as the battery temperature T and the current value I included in the battery load history. The battery database 54 also stores, for each secondary battery 25, battery characteristic information indicating characteristics related to the progress of degradation of the secondary battery 25.

The driver database 55 includes driver information input from the information terminal 10 of each driver Dr. The driver database 55 includes information on an operation schedule route, a work state, and traveling characteristics (such as frequency of operating accelerator and brake, degree of acceleration and deceleration) of the driver Dr.

As illustrated in FIG. 3, the control unit 51 includes a usage history acquisition unit 51a, a deterioration estimation unit 51b, a battery load acquisition unit 51c, a deterioration change degree identification unit **51d,** a battery management unit 51e, a profit estimation unit 51f, and a battery characteristic learning unit 51g as functional units of the battery management system 1. The usage history acquisition unit 51a is a functional unit that acquires, from each vehicle V, a battery load history as usage history information indicating a usage history of the secondary battery 25 during a period in which the secondary battery is mounted on the vehicle V, and is realized by, for example, the control unit 51 executing step S2 described later.

The deterioration estimation unit 51b is a functional unit that estimates a current deterioration state of the secondary battery 25 and a deterioration factor that has caused the deterioration state on the basis of the battery load history, and is realized by, for example, the control unit 51 executing processing from step S3 to step S5 described later.

The battery load acquisition unit 51c is a functional unit that acquires a predicted battery load as battery load information calculated using a future usage mode of the secondary battery 25 in the vehicle V. The battery load acquisition unit 51c is realized by, for example, the control unit 51 executing step S6 described later.

The deterioration change degree identification unit 51d is a functional unit that identifies a deterioration change degree indicating a change in the deterioration state of the secondary battery 25 at the time when the scheduled use period elapses, using the current deterioration state and the deterioration factor of the secondary battery 25 and the predicted battery load of the secondary battery 25. The deterioration change degree identification unit 51d is realized by, for example, the control unit 51 executing step S7 and step S8 described later.

The battery management unit 51e is a functional unit that associates the secondary batteries 25 with the future usage modes using the deterioration change degree of the secondary batteries 25 so that the evaluation value indicating the degree of deterioration of the secondary batteries 25 in the vehicles V becomes the minimum value. The battery management unit 51e is configured by, for example, the control unit 51 executing step S11 and step S12 described later.

The profit estimation unit 51f is a functional unit that estimates a profit obtained in a usage mode of the secondary battery 25 associated with the vehicle V, and is realized by, for example, the control unit 51 executing step S11 described later.

The battery characteristic learning unit 51g is a functional unit that learns battery characteristic information indicating characteristics related to progress of deterioration of the secondary battery 25 using the current deterioration state of the secondary battery 25 and the deterioration state of the secondary battery 25 calculated in step S4. The battery characteristic learning unit 51g is realized by, for example, the control unit 51 executing step S4.

At least one of the functions of the battery management system 1 may be configured by an electronic circuit (i.e., hardware) for performing the function.

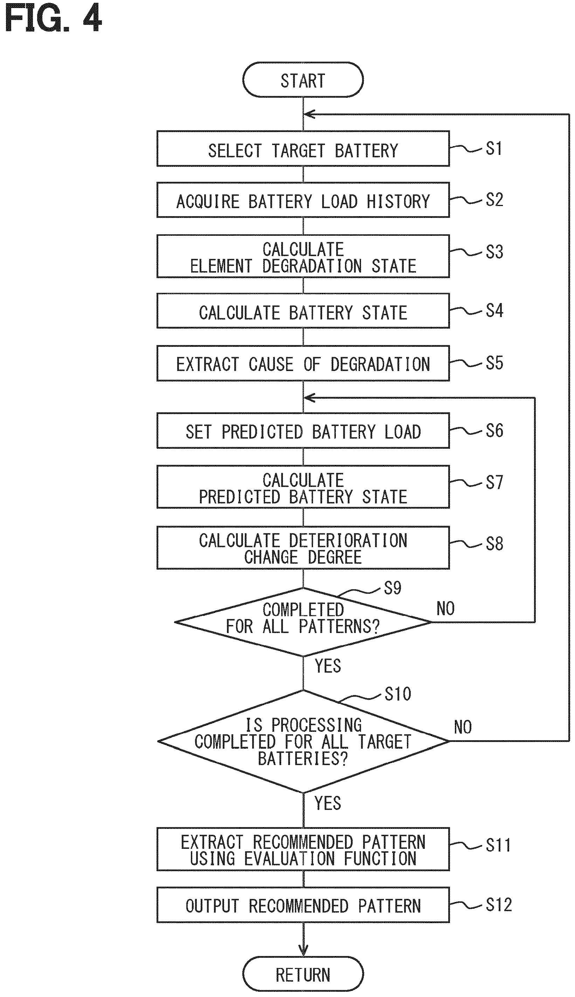

Next, the processing steps of the battery management process by the battery management system 1 according to the first embodiment will be described with reference to the flowchart shown in FIG. 4. In the following description, it is assumed that battery management system 1 includes five vehicles V1 to V5, and the secondary batteries 25 mounted on the vehicles V1 to V5 are referred to as secondary batteries (1) to (5) when being distinguished from each other. For example, the secondary battery (2) means the secondary battery 25 mounted on the vehicle V2, and the secondary battery (4) means the secondary battery 25 mounted on the vehicle V4.

Further, it is assumed that four drivers Dr, such as a driver Dr1 to a driver Dr4, belong to the battery management system 1, and that different driving routes are associated with the respective drivers Dr. When the driving routes of the drivers Dr are distinguished from each other, the driving routes are referred to as routes (1) to (4). For example, the route (2) means an operation route associated with the driver Dr2, and the route (3) means an operation route associated with the driver Dr3.

As shown in FIG. 4, first, in step S1, one target battery is selected from the secondary batteries 25 of the battery management system 1. The target battery means the secondary battery 25 for which the current deterioration amount or the like is calculated in the battery management process. After the target battery is specified, the process proceeds to step S2.

In step S2, the battery load history of the secondary battery 25 selected as the target battery is acquired from the vehicle V on which the target battery is mounted using the communication unit 52. At this time, the battery load history of the target battery may be acquired from the battery database 54. The battery load history corresponds to the usage history information. Thus, the battery management system 1 can acquire the battery load history of the secondary battery 25 without disassembling the secondary battery 25 (that is, the battery pack).

The battery load history, as usage history information, includes a history of loads acting on the secondary battery 25, such as the battery temperature T, which is a temperature of the secondary battery 25, a charge/discharge current, and a use period. In a case where data forming the battery load history is missing due to a standing period or the like, the control unit 51 performs interpolation processing of interpolating a missing portion using an existing value. The content of the interpolation processing will be described later.

When the processing proceeds to step S3, element degradation states $SOHQ_a e$, $SOHQ_c e$, $SOHQ_{Li} e$, $SOHR_a e$, and $SOHR_c e$ of the secondary battery 25 as the target battery are calculated using the acquired battery load history. SOH stands for state of health.

$SOHQ_a e$ is a capacity retention rate of the negative electrode of the secondary battery 25 at the present time. $SOHQ_c e$ is a capacity retention rate of the positive electrode of the secondary battery 25 at the present time. $SOHQ_{Li} e$ is the capacity retention rate of the electrolyte of the secondary battery 25 at the present time. $SOHR_a e$ is a resistance increase rate of the negative electrode of the secondary battery 25 at the present time. $SOHR_c e$ is a resistance increase rate of the positive electrode of the secondary battery 25 at the present time.

The capacity retention rate of each component (i.e., negative electrode, positive electrode, and electrolyte) of the secondary battery 25 at a predetermined time (arbitrary time after start of use) is a ratio of the capacity of each component of the secondary battery 25 at the predetermined time to the capacity of each component in the initial state (e.g., at time of factory shipment). The negative electrode capacity corresponds to the number of sites of the negative electrode into which lithium ions can be inserted. The positive electrode capacity corresponds to the number of sites of the positive electrode into which lithium ions can be inserted.

The capacity of the electrolyte is expressed by using the positive-negative electrode SOC deviation capacity. The positive-negative electrode SOC deviation capacity is a deviation between used capacity regions of the positive electrode and the negative electrode in the secondary battery 25. The positive-negative electrode SOC deviation capacity corresponds to the number of lithium ions that can move between the positive electrode and the negative electrode and ease of movement of all lithium ions.

The resistance increase rate of each component of the secondary battery 25 at a predetermined time (arbitrary time after temporary use is started) is a ratio of the resistance value of each component of the secondary battery 25 at the predetermined time to the resistance value of each component in the initial state.

The battery management system 1 calculates each of the element degradation states $SOHQ_ae$, $SOHQ_ce$, $SOHQ_{Li}e$, $SOHR_ae$, and $SOHR_ce$ on the basis of a plurality of causes of degradation related to each battery component. That is, the battery management system 1 calculates the element degradation states $SOHQ_ae$ and $SOHR_ae$ related to the negative electrode on the basis of the plurality of causes of degradation of the negative electrode of the secondary battery 25. In addition, the battery management system 1 calculates the element degradation states $SOHQ_ce$ and $SOHR_ce$ related to the positive electrode on the basis of a plurality of causes of degradation of the positive electrode. Further, the battery management system 1 calculates the element degradation state $SOHQ_{Li}e$ related to the electrolyte on the basis of a plurality of causes of degradation of the electrolyte.

Specifically, each of a negative electrode capacity Qa and a negative electrode resistance Ra is calculated in consideration of a cause of degradation brought about by formation of a film on the surface of the active material, a cause of degradation brought about by cracking of the film formed on the surface of the active material, and a cause of degradation brought about by cracking of the active material itself.

Each of a positive electrode capacity Qc and a positive electrode resistance Rc is calculated in consideration of a cause of degradation brought about by the alteration of the surface of the active material, a cause of degradation brought about by cracking of the altered surface of the active material, and a cause of degradation in consideration of cracking of the active material itself.

In addition, the element degradation state $SOHQ_{Li}e$ of the electrolyte is calculated in consideration of a cause of degradation brought about by formation of a film on the surface of the active material of the negative electrode, a cause of degradation brought about by cracking of the film formed on the surface of the active material of the negative electrode, and a cause of degradation brought about by cracking of the active material itself of the negative electrode. Further, the element degradation state $SOHQ_{Li}e$ of the electrolyte is calculated in consideration of a cause of degradation brought about by formation of a film on the surface of the active material of the positive electrode, a cause of degradation brought about by cracking of the film formed on the surface of the active material of the positive electrode, and a cause of degradation brought about by cracking of the active material itself of the positive electrode.

A detailed method of calculating each element degradation state will be described later.

In step S4, battery states $SOHQ_Be$ and $SOHR_Be$, which are degradation states of the entire secondary battery 25 as a target battery, are calculated. The battery state $SOHQ_Be$ indicates a degradation state of the entire secondary battery 25 related to the capacity of the secondary battery 25. The battery state $SOHQ_Be$ is derived by taking the minimum value of the element degradation states $SOHQ_ae$, $SOHQ_ce$, and $SOHQ_{Li}e$ calculated in step S3. That is, $SOHQ_Be = \min (SOHQ_ae, SOHQ_ce, SOHQ_{Li}e)$.

As described above, the negative electrode capacity Qa corresponds to the number of sites of the negative electrode into which lithium ions can be inserted, and the positive electrode capacity Qc corresponds to the number of sites of the positive electrode into which lithium ions can be inserted. A positive-negative electrode SOC deviation capacity QLi corresponds to the number of lithium ions that can move between the positive electrode and the negative electrode and ease of movement of all lithium ions.

Therefore, the smallest one of the negative electrode capacity Qa, the positive electrode capacity Qc, and the positive-negative electrode SOC deviation capacity QLi corresponds to a battery capacity QB of the secondary battery 25. That is, the minimum value of the element degradation states $SOHQ_ae$, $SOHQ_ce$, and $SOHQ_{Li}e$ becomes the battery state $SOHQ_Be$ of the entire secondary battery 25.

In addition, the battery state $SOHR_Be$ indicates a degradation state of the entire secondary battery 25 related to resistance. The battery state $SOHR_Be$ is calculated by the sum of the element degradation states $SOHR_ae$ and $SOHR_ce$. That is, $SOHR_Be = SOHR_ae + SOHR_ce$.

For example, in a case where the resistance of a member (e.g., electrolyte) other than the electrode (i.e., negative electrode and positive electrode) of the secondary battery 25 is considered for the element degradation state, the element degradation state regarding the member is considered when the battery state $SOHR_Be$ is calculated. That is, the element degradation state related to the member is added to the right side of $SOHR_Be = SOHR_ae + SOHR_ce$.

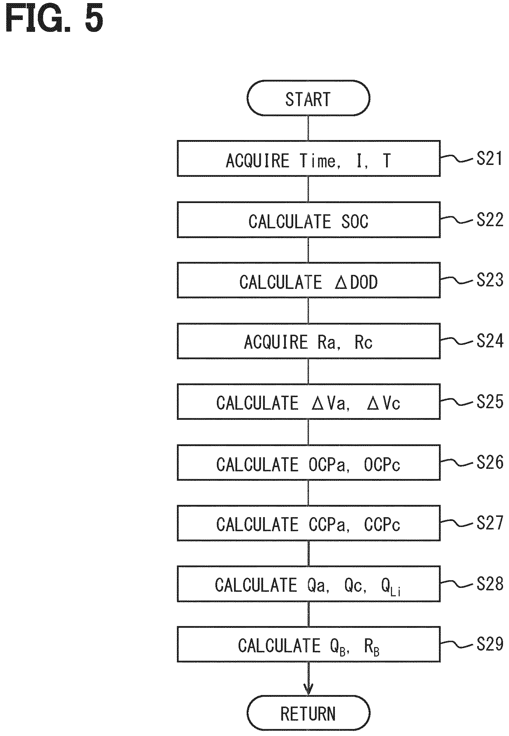

Here, the acquisition of the battery load history in step S2, the calculation of the element degradation state in step S3, and the calculation of the battery state in step S4 will be described in detail with reference to FIG. 5.

The battery management system 1 sequentially calculates the element degradation state of the secondary battery 25 from the start of use up to the present time on the basis of the battery load history of the secondary battery 25. Hereinafter, the start time of one operation of calculating the element degradation state is referred to as ts, the end time thereof is referred to as te, and the time from the start time ts to the end time te is referred to as an execution cycle. The length of the execution cycle is appropriately determined in consideration of the accuracy of prediction regarding the element degradation state and the battery state and the calculation load regarding calculation of the element degradation state and the battery state.

As described above, in step S2, the control unit 51 acquires the battery load history transmitted from the vehicle V on which the target battery is mounted. Specific contents of step S2 will be described in step S21.

In step S21, the battery temperature T, the charge/discharge current value I, and the history target period Time are acquired as the battery load history.

At this time, the battery management system 1 calculates the battery temperature T of the secondary battery 25 in the execution cycle from the temperature distribution of the secondary battery 25 during the execution cycle. The battery temperature T can be, for example, an average value calculated from a frequency distribution of the temperature of the secondary battery 25 acquired during the execution cycle.

As the battery temperature T, it is also possible to adopt an average value or the like of temperatures of the secondary battery 25 acquired during the execution cycle in order to reduce the calculation load. The battery temperature T is stored in the battery database 54 of the battery management system 1.

The battery load history acquired from the vehicle V includes a use period Pe in which the ignition of the vehicle V is on and there is input and output to and from the secondary battery 25, and a standing period Pel in which the ignition is off and there is no input and output to and from the secondary battery 25.

In the standing period Pel, since a detection operation of various sensors such as the battery temperature sensor 28 is not performed, it is conceivable that the battery load history corresponding to the standing period Pel included in the history target period Time may be missing. However, in order to evaluate the progress of calendar degradation described later, the battery load history of the standing period Pel is also required.

Therefore, in step S21, data interpolation processing is performed to interpolate missing constituent data in the battery load history. In the data interpolation processing, data corresponding to the standing period Pel is estimated and complemented from data corresponding to the use period Pe acquired as the battery load history, and the battery load history in all periods is acquired.

Specifically, in step S21, interpolation processing is performed on the voltage, the SOC, the current, and the battery temperature T included in the battery load history. In the following description, the use period Pe immediately before the standing period Pel is referred to as an immediately preceding use period Peb, and the use period Pe immediately after the standing period Pel is referred to as an immediately following use period Pea.

In the interpolation processing related to the voltage and the SOC, the numerical value of the voltage or the like in the standing period Pel is linearly interpolated using the numerical value of the voltage or the like at the end of the immediately preceding use period Peb and the numerical value of the voltage or the like in the immediately following use period Pea. In the interpolation processing related to the current value I, since there is no input or output to or from the secondary battery 25, the current value I in the standing period Pel is estimated to be "0" and interpolation is performed.

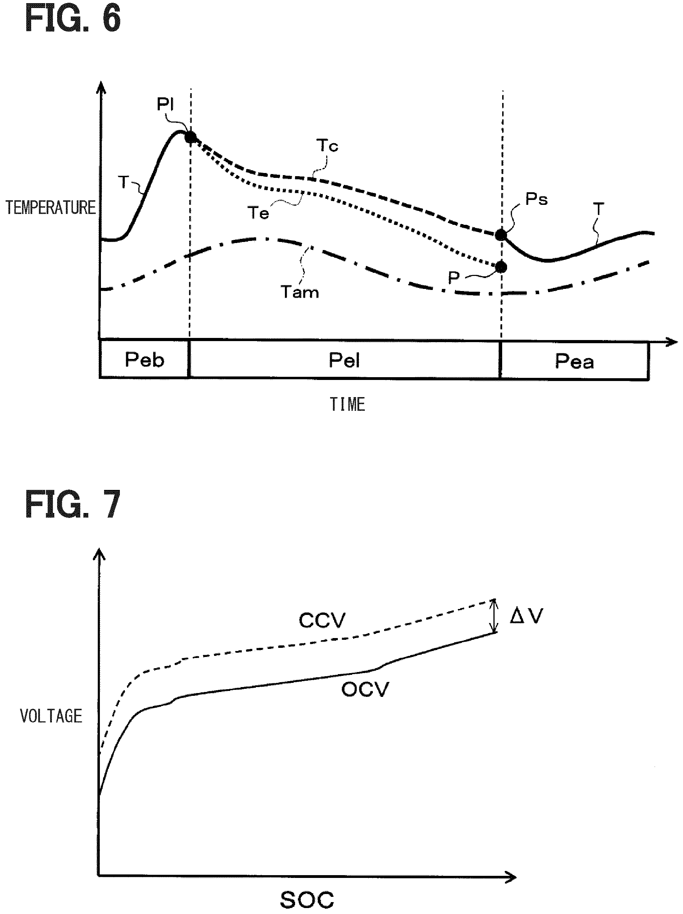

The content of the interpolation processing related to the battery temperature T will be described with reference to FIG. 6. As illustrated in FIG. 6, the value of the battery temperature T at point Pl at the end of the immediately preceding use period Peb and the value of the battery temperature T at point Ps at the start of the immediately following use period Pea are known.

An outside air temperature Tam around the secondary battery 25 in the standing period Pel can be acquired through the network N or the like, and is a known value for the entire the standing period Pel. Data sampling in the standing period Pel is performed N times in a sampling cycle $\Delta t$. Therefore, the length of the standing period Pel can be expressed as $\Delta tN$.

First, in the standing period Pel, the relationship between the battery temperature $T_n$ related to the n-th sampling and the battery temperature $T_{n-1}$ related to the (n-1) th sampling can be expressed by the following formula (1).

[Mathematical formula 1]

$$T_n = T_{n-1} + \Delta T_n \qquad (1)$$

Here, $\Delta T_n$ is a change amount of the battery temperature T from the time point of the (n-1) th sampling to the time point of the n-th sampling. Here, $\Delta T_n$ can be expressed as the following formula (2) in consideration of the outside air heat dissipation resistance of the secondary battery 25, the heat capacity of the secondary battery 25, and the outside air temperature Tam around the secondary battery 25.

[Mathematical formula 2]

$$\Delta T_n = \frac{(T_{n-1} - Tam_{n-1})}{R} \times \frac{\Delta t}{C} \qquad (2)$$

In formula (2), R represents the outside air heat dissipation resistance of the secondary battery 25, and C represents the heat capacity of the secondary battery 25. In addition, $Tam_{n-1}$ is the outside air temperature Tam at the time of the (n-1) th sampling. Since these values are known values, it is possible to derive a temperature profile Te in consideration of the outside air temperature Tam, the outside air heat dissipation resistance and the heat capacity of the secondary battery 25 by formulae (1) and (2).

Using the derived temperature profile Te and the value (actual measured value) of a battery temperature Ts at point Ps at the start of the immediately following use period Pea, the temperature profile Te is corrected in proportion to time. A correction value Tc can be expressed by the following formula (3).

[Mathematical formula 3]

$$Tc_n = T_n + (Ts - T_N) \times \frac{\Delta tn}{\Delta tN} \quad (3)$$

In formula (3), $Tc_n$ represents a value of the correction value Tc corresponding to the n-th sampling time point. In addition, $T_N$ is a value of the temperature profile Te at the start point of the immediately following use period Pea, and represents point P in FIG. 6.

As described above, by performing the interpolation processing in step S21, the battery temperature T in the standing period Pel can be accurately interpolated in consideration of the outside air heat dissipation resistance and heat capacity of the secondary battery 25 and the outside air temperature Tam around the secondary battery 25.

In step S22, the battery management system 1 calculates an integrated value of the current value I of the secondary battery 25, and calculates the state of charge of the secondary battery 25 on the basis of the calculated integrated value. The state of charge is a ratio of the remaining capacity to the full charge capacity of the secondary battery 25 expressed in percentage, and is the so-called SOC (i.e., state of charge). Hereinafter, the state of charge of the secondary battery 25 is referred to as SOC. The battery management system 1 calculates the SOC of the secondary battery 25 on the basis of the integrated value of the current value of the secondary battery 25 using, for example, a current integration method.

In step S23, the battery management system 1 calculates ΔDOD. Here, ΔDOD is calculated by a difference between the SOC at the start time ts of the execution cycle and the SOC at the end time te thereof. DOD stands for depth of discharge indicating the depth of discharge of the secondary battery 25.

In step S24, the battery management system 1 calculates the negative electrode resistance $R_a$ and the positive electrode resistance $R_c$ of the secondary battery 25. The negative electrode resistance $R_a$ is calculated on the basis of the battery temperature T of the secondary battery 25, the current value I of the secondary battery 25, the change amount ΔDOD of the SOC, and the closed circuit potential of the negative electrode of the secondary battery 25. The positive electrode resistance $R_c$ is calculated on the basis of the battery temperature T of the secondary battery 25, the current value I of the secondary battery 25, the change amount ΔDOD of the SOC, and the closed circuit potential of the positive electrode.

Here, the battery temperature T is the battery temperature T of the secondary battery 25 calculated in step S21. The current value I is a current value I of the secondary battery 25 calculated in step S21. The change amount ΔDOD is ΔDOD calculated in step S23.

The closed circuit potential of the negative electrode and the closed circuit potential of the positive electrode of the secondary battery 25 are the closed circuit potentials of the negative electrode and the positive electrode of the secondary battery 25 calculated in the previous execution cycle. Hereinafter, the closed circuit potential of the negative electrode of the secondary battery 25 is referred to as $CCP_a$, and the closed circuit potential of the positive electrode of the secondary battery 25 is referred to as $CCP_c$. CCP stands for closed circuit potential.

The negative electrode resistance $R_a$ can be expressed as a function of the battery temperature T of the secondary battery 25, the negative electrode side closed circuit potential $CCP_a$, the change amount ΔDOD, and the charge-discharge current value I. The positive electrode resistance $R_c$ can be expressed as a function of the temperature T of the secondary battery 25, the positive electrode side closed circuit potential $CCP_c$, the change amount ΔDOD, and the charge-discharge current value I. A specific description will be given below.

The negative electrode resistance $R_a$ increases due to formation of a film (solid electrolyte interface (SEI)) on the surface of the negative electrode by oxidation-reduction decomposition of the electrolytic solution of the secondary battery 25 and additives thereof. Since the film is generated by the above-described chemical reaction, the negative electrode resistance $R_a$ follows the Arrhenius law. Therefore, the negative electrode resistance Ra can be expressed by a function of the battery temperature T.

In addition, since the film formation on the surface of the negative electrode is caused by oxidation-reduction, the film formation follows the Tafel's law. Therefore, the negative electrode resistance $R_a$ can be expressed by a function of the negative electrode side closed circuit potential $CCP_a$.

When the charge-discharge cycle of the secondary battery 25 is repeated, expansion and contraction of the active material of the negative electrode are repeated, and cracking of the surface film progresses, so that the negative electrode surface is eventually exposed from the crack of the film. Since a new film is formed on the surface exposed from the crack, the film amount increases, which causes a further increase in the negative electrode resistance $R_a$. The larger the change amount $\Delta$DOD, the larger the degree of expansion and contraction of the active material. Therefore, the negative electrode resistance $R_a$ can be expressed by a function of the change amount $\Delta$DOD.

In addition, in the negative electrode, due to repeated expansion and contraction of the active material, the active material itself cracks and the diameter thereof decreases. Cracking of the active material itself includes both an element for decreasing the negative electrode resistance $R_a$ and an element for increasing the negative electrode resistance $R_a$.

First, a new surface (i.e., surface on which film is not formed) is formed on the active material due to cracking of the active material itself, so that the reaction area increases. Therefore, cracking of the active material itself causes a decrease in the negative electrode resistance $R_a$. On the other hand, when a new surface is formed on the active material, film formation is promoted on the new surface, so that the film amount increases and the negative electrode resistance $R_a$ increases. In consideration of the above, the negative electrode resistance $R_a$ can be expressed by a function of the change amount $\Delta$DOD from the following theory.

The pulverization rate, which is the rate of cracking of the active material of the negative electrode, is expressed by dr/dt when the particle size of the active material is r and the time is t. Here, it is considered that the pulverization rate dr/dt is more likely to proceed as the particle size r of the active material is larger. That is, the pulverization rate dr/dt can be considered to be proportional to the particle size r of the active material. Therefore, the pulverization rate dr/dt can be expressed by the following formula (4).

[Mathematical formula 4]

$$\frac{\mathrm{dr}}{\mathrm{dt}} = -\mathrm{k} \times \mathrm{r} \quad (4)$$

In formula (4), k is a constant, and hereinafter may be referred to as a pulverization coefficient. When this is solved, the following formula (5) is obtained.

[Mathematical formula 5]

$$\ln(\mathrm{r}) = -\mathrm{k} \times \mathrm{t} + \alpha \quad (5)$$

In formula (5), $\alpha$ is a constant.

Further, since the degree of expansion and contraction of the active material increases as the change amount $\Delta$DOD of the active material increases, it is considered that the pulverization constant is proportional to the change amount $\Delta$DOD. Then, the following formula (6) holds.

[Mathematical formula 6]

$$\ln(\mathrm{k}) = \beta \times \Delta\mathrm{DOD} + \gamma \quad (6)$$

In formula (6), $\beta$ and $\gamma$ are constants. When this is solved, the following formula (7) is obtained.

[Mathematical formula 7]

$$\mathrm{k} = \eta \times \exp(\zeta \times \Delta\mathrm{DOD}) \quad (7)$$

In formula (7), $\eta$ and $\zeta$ are constants. When formula (5) and formula (7) are coupled, the following formula (8) can be derived.

[Mathematical formula 8]

$$\mathrm{r}(\mathrm{t}, \Delta\mathrm{DOD}) = \mathrm{r}_0\{1 - \mathrm{A} \times \exp[\mathrm{B} \times \langle\exp(\mathrm{C} \times \Delta\mathrm{DOD})\rangle \times \mathrm{t}]\} \quad (8)$$

$$\mathrm{f}(\mathrm{t}, \Delta\mathrm{DOD}) \equiv \mathrm{A} \times \exp[\mathrm{B} \times \langle\exp(\mathrm{C} \times \Delta\mathrm{DOD})\rangle \times \mathrm{t}] \quad (9)$$

Here, $r_0$ is a radius of the active material at an initial stage (i.e., when t = 0), and A, B, and C are constants. As described above, the negative electrode resistance $R_a$ increases due to the formation of the film on the surface of the negative electrode, and the formation rate of the film on the surface of the negative electrode has a correlation with the diameter of the active material of the negative electrode. Therefore, the negative electrode resistance $R_a$ can be expressed by a formula (i.e., function of $\Delta$DOD) including a pulverization function f (t, $\Delta$DOD). Each parenthesis on

the right side of formula (5) may be further added and corrected with a constant.

The cracking of the surface film of the negative electrode and the cracking of the negative electrode active material itself also depend on the charge-discharge current value I of the secondary battery 25. As the charge-discharge current value I increases, the current tends to intensively flow through a low resistance portion of the active material, so that the degree of expansion and contraction may vary depending on the portion of the active material. As a result, strain is likely to occur in the active material, which causes cracking of the surface film of the negative electrode and cracking of the negative electrode active material itself.

Therefore, the cracking of the negative electrode surface film and the cracking of the negative electrode active material itself can be expressed by a function of the charge-discharge current value I or a function of the C rate correlated with the charge-discharge current value I. Here, the 1C rate indicates a current value at which the rated capacity of the battery is fully charged or fully discharged in one hour in the case of constant current charge/discharge measurement.

To summarize the above, the negative electrode resistance $R_a$ is expressed by the following formula (7) using a function $g_A$ (T, $CCP_a$), a function $g_B$ (T, $CCP_a$, $\Delta DOD$, I), and a function $g_C$ (T, $CCP_a$, $\Delta DOD$, I).

Here, the function $g_A$ (T, $CCP_a$) is a function considering that a film is formed on the surface of the active material. The function $g_B$ (T, $CCP_a$, $\Delta DOD$, I) is a function in consideration of cracking of the film formed on the surface of the active material. The function $g_C$ (T, $CCP_a$, $\Delta DOD$, I) is a function in consideration of cracking of the active material itself.
[Mathematical formula 9]

$$R_a = g_A(T, CCP_a) \times g_B(T, CCP_a, \Delta DOD, I) \times g_C(T, CCP_a, \Delta DOD, I) \quad (10)$$

On the basis of the above theory, the negative electrode resistance Ra is expressed as a function of the battery temperature T of the secondary battery 25, the negative electrode side closed circuit potential $CCP_a$, the change amount $\Delta DOD$, and the charge-discharge current value I.

Next, the positive electrode resistance $R_c$ will be described. The positive electrode resistance $R_c$ increases as the surface of the positive electrode is altered. Since the surface of the positive electrode is altered by a chemical reaction, the positive electrode resistance $R_c$ follows the Arrhenius law. Therefore, the positive electrode resistance Rc can be expressed by a function of the battery temperature T.

In addition, since the alteration of the surface of the positive electrode is caused by reductive decomposition of the surface of the positive electrode, the alteration follows the Tafel's law. Therefore, the positive electrode resistance $R_c$ can be expressed by a function of the positive electrode side closed circuit potential $CCP_c$.

When the charge-discharge cycle of the secondary battery 25 is repeated and the expansion and contraction of the active material of the positive electrode are repeated, a crack occurs on the surface of the altered positive electrode active material, and a new positive electrode surface that is not altered is formed. The alteration eventually occurs on the new positive electrode surface, thereby causing a further increase in the positive electrode resistance $R_c$. Since the degree of expansion and contraction of the active material increases as the change amount $\Delta DOD$ increases, the positive electrode resistance $R_c$ can be expressed by a function of the change amount $\Delta DOD$.

In addition, the alteration of the surface of the positive electrode is promoted by repeated expansion and contraction of the active material of the positive electrode, so that cracking of the active material of the positive electrode progresses, and the diameter of the active material decreases. Cracking of the active material itself includes both an element for decreasing the positive electrode resistance $R_c$ and an element for increasing the positive electrode resistance $R_c$.

First, since a new surface (i.e., surface before alteration) is formed on the active material by cracking of the active material itself, the cracking of the active material itself causes a decrease in the positive electrode resistance $R_c$. On the other hand, when a new surface is formed on the active material, the formed new surface is eventually altered, and the positive electrode resistance $R_c$ increases. In consideration of the above, the positive electrode resistance $R_c$ can be expressed by a formula (i.e., function of $\Delta DOD$) including the pulverization function f (t, $\Delta DOD$) of formula (9) from the same theory as the negative electrode resistance $R_a$.

Cracking of the positive electrode active material itself also depends on the charge-discharge current value I. As the charge-discharge current value I increases, the current tends to intensively flow through a low resistance portion of the active material, so that the degree of expansion and contraction may vary depending on the portion of the active material. As a result, strain is likely to occur in the active material itself, which causes cracking of the positive electrode active material itself. Therefore, the cracking of the positive electrode active material itself can be expressed by a function of the charge-discharge current value I or a function of the C rate correlated with the charge-discharge current value I.

To summarize the above, the positive electrode resistance $R_c$ can be expressed by the following formula (11) using functions $h_A$, (T, $CCP_c$), $h_B$ (T, $CCP_c$, $\Delta DOD$, I), and $h_C$ (T, $CCP_c$, $\Delta DOD$, I).

Here, the function $h_A$, (T, $CCP_c$) is a function in consideration of the alteration of the surface of the active material. The function $h_B$ (T, $CCP_c$, $\Delta DOD$, I) is a function in consideration of cracking of the altered surface of the active material. The function $h_C$ (T, $CCP_c$, $\Delta DOD$, I) is a function in consideration of cracking of the active material itself.

[Mathematical formula 10]

$$R_c = h_A(T, CCP_c) \times h_B(T, CCP_c, \Delta DOD, I) \times h_C(T, CCP_c, \Delta DOD, I) \quad (11)$$

On the basis of the above theory, the positive electrode resistance $R_c$ is expressed as a function of the battery temperature $T$ of the secondary battery 25, the positive electrode side closed circuit potential $CCP_c$, the change amount $\Delta DOD$, and the charge-discharge current value $I$.

Here, in step S24, as the negative electrode side closed circuit potential $CCP_a$ and the positive electrode side closed circuit potential $CCP_c$ used for calculating the negative electrode resistance $R_a$ and the positive electrode resistance $R_c$, the negative electrode side closed circuit potential $CCP_a$ and the positive electrode side closed circuit potential $CCP_c$ in the previous execution cycle of the current execution cycle are used. The negative electrode side closed circuit potential $CCP_a$ and the positive electrode side closed circuit potential $CCP_c$ are calculated in step S27 in the immediately preceding execution cycle.

When the negative electrode side closed circuit potential $CCP_a$ and the positive electrode side closed circuit potential $CCP_c$ calculated in the previous execution cycle are not present (e.g., at time of system activation or the like), the initial negative electrode side closed circuit potential $CCP_a$ and the initial positive electrode side closed circuit potential $CCP_c$ are calculated as follows.

First, an initial polarization $\Delta V_a$ of the negative electrode is calculated from the product of the current value $I$ calculated in step S21 and the initial value of the negative electrode resistance $R_a$, and an initial polarization $\Delta V_c$ of the positive electrode is calculated from the product of the current value $I$ calculated in step S21 and the initial value of the positive electrode resistance $R_c$. The initial value of the negative electrode resistance $R_a$ and the initial value of the positive electrode resistance $R_c$ are, for example, values of the negative electrode resistance and the positive electrode resistance in an initial state (e.g., state at time of factory shipment) in a secondary battery of the same type as the secondary battery 25 mounted on the vehicle V.

The initial values of the negative electrode resistance and the positive electrode resistance of the secondary battery 25 are stored in, for example, the battery database 54 of the battery control unit 30 of the vehicle V or the management server 50, and can be acquired from the battery control unit 30 or the battery database 54. The negative electrode resistance $R_a$ and the positive electrode resistance $R_c$ in the initial state can be determined by, for example, an AC impedance method, IV measurement, or the like. Alternatively, the negative electrode resistance $R_a$ and the positive electrode resistance $R_c$ in the initial state can also be determined by preparing a half cell using the positive electrode and a half cell using the negative electrode of the disassembled secondary battery 25 in the initial state and measuring the resistance of each half cell.

The open circuit potentials of the negative electrode and the positive electrode of the secondary battery are calculated on the basis of an initial OCP characteristic described later and the SOC calculated in step S22. Each open circuit potential is a potential of each electrode of the secondary battery 25 when a state in which the secondary battery 25 and the external circuit are not energized has elapsed for a long period of time. Hereinafter, the open circuit potential of the negative electrode of the secondary battery 25 is referred to as a negative electrode side open circuit potential $OCP_a$, and the open circuit potential of the positive electrode of the secondary battery 25 is referred to as a positive electrode side open circuit potential $OCP_c$. OCP stands for open circuit potential.

The initial OCP characteristic indicates a relationship between the SOC of the secondary battery 25 and the negative electrode side open circuit potential $OCP_a$ and a relationship between the SOC of the secondary battery 25 and the positive electrode side open circuit potential $OCP_c$ in the initial state, and is stored in, for example, the battery database 54.

Subsequently, the negative electrode side closed circuit potential $CCP_a$ is obtained by adding the negative electrode side open circuit potential $OCP_a$ and the negative electrode side polarization $\Delta V_a$. On the other hand, the positive electrode side closed circuit potential $CCP_c$ can be obtained by adding the positive electrode side open circuit potential $OCP_c$ and the positive electrode side polarization $\Delta V_c$.

When the negative electrode side closed circuit potential $CCP_a$ and the positive electrode side closed circuit potential $CCP_c$ calculated in the previous execution cycle are not present (e.g., at time of system activation or the like), the initial negative electrode side closed circuit potential $CCP_a$ and the initial positive electrode side closed circuit potential $CCP_c$ are calculated by performing the above processing.

When the negative electrode resistance $R_a$ and the positive electrode resistance $R_c$ are calculated according to the above-described theory and the processing proceeds to step S25, the battery management system 1 calculates the polarization $\Delta V_a$ of the negative electrode and the polarization $\Delta V_c$ of the positive electrode. The polarization $\Delta V_a$ of the negative electrode is calculated by multiplying the current value $I$ of the secondary battery 25 calculated in step S21 by the negative electrode resistance $Ra$ calculated in step S24. On the other hand, the polarization $\Delta V_c$ of the positive electrode is calculated by multiplying the current value $I$ of the secondary battery 25 by the positive electrode resistance $R_c$ calculated in step S24.

When the processing proceeds to step S26, the battery management system 1 calculates the negative electrode side open circuit potential $OCP_a$ and the positive electrode side open circuit potential $OCP_c$. The battery management system 1 calculates the negative electrode side open circuit potential $OCP_a$ and the positive electrode side open circuit potential $OCP_c$ on the basis of the SOC of the secondary battery 25 calculated in step S22 and the updated OCP characteristic of the previous execution cycle stored in the battery database 54. The updated OCP characteristic indicates a relationship between the SOC and the negative electrode side open circuit potential $OCP_a$ and a relationship between the SOC and the positive electrode side open circuit potential $OCP_c$ in the secondary battery 25 after degradation.

Here, the updated OCP characteristic can be acquired as follows. First, the initial OCP characteristic stored in advance in the battery database 54 of the battery management system 1 is updated on the basis of the negative electrode capacity $Q_a$, the positive electrode capacity $Q_c$, and the positive-negative electrode SOC deviation capacity $Q_{Li}$ calculated in step S28 described later.

The initial OCP characteristic indicates a relationship between the SOC and the negative electrode side open circuit potential $OCP_a$ and a relationship between the SOC and the positive electrode side open circuit potential $OCP_c$ in the secondary battery 25 in the initial state. The method of updating the initial OCP characteristic is not particularly limited, and, for example, a known method can be adopted.

In step S27, the battery management system 1 calculates a negative electrode side closed circuit potential $CCP_a$ and a positive electrode side closed circuit potential $CCP_c$ of the secondary battery 25. First, the battery management system 1 acquires the polarization $\Delta V_a$ and the polarization $\Delta V_c$ calculated in step S25, and acquires the negative electrode side open circuit potential $OCP_a$ and the positive electrode side open circuit potential $OCP_c$ calculated in step S26.

The negative electrode side closed circuit potential $CCP_a$ is calculated by adding the negative electrode side open circuit potential $OCP_a$ and the polarization $\Delta V_a$ of the negative electrode, and the negative electrode side open circuit potential $OCP_a$ can be rewritten to the negative electrode side closed circuit potential $CCP_a$. Similarly, the positive electrode side closed circuit potential $CCP_c$ is calculated by adding the positive electrode side open circuit potential $OCP_c$ and the polarization $\Delta V_c$ of the positive electrode, and the positive electrode side open circuit potential $OCP_c$ can be rewritten to the positive electrode side closed circuit potential $CCP_c$.

Here, polarization of the secondary battery 25 becomes apparent due to degradation. That is, due to the occurrence of polarization, the closed circuit voltage of the secondary battery 25 increases during charging of the secondary battery 25, and the closed circuit voltage decreases during discharging. As the degradation of the secondary battery 25 progresses, the closed circuit voltage further increases during charging of the secondary battery 25, and the closed circuit voltage further decreases during discharging.

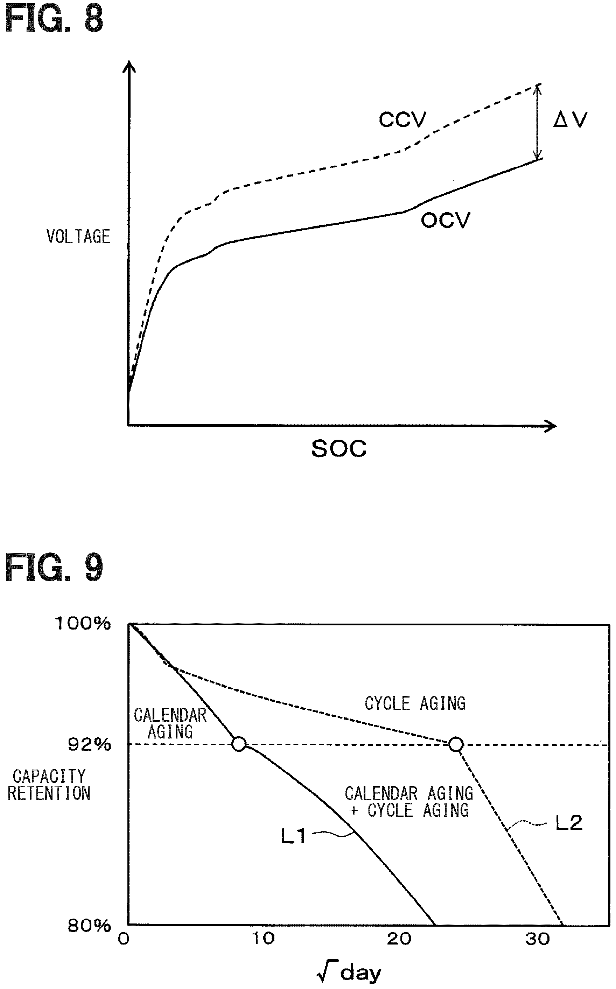

This point will be described with reference to FIGS. 7 and 8. FIG. 7 schematically illustrates the relationship between the SOC and the voltage during charging with respect to the secondary battery 25 before degradation, and FIG. 8 schematically illustrates the relationship between the SOC and the voltage during charging with respect to the secondary battery 25 after degradation. In FIGS. 7 and 8, the open circuit voltage is represented by a solid line, the closed circuit voltage is represented by a broken line, and the scales of the voltages on the vertical axis coincide with each other.

Hereinafter, the open circuit voltage is referred to as OCV, and the closed circuit voltage is referred to as CCV. OCV stands for open circuit voltage, and CCV stands for closed circuit voltage.

Referring to FIGS. 7 and 8, it can be seen that the polarization $\Delta V$ of the secondary battery 25 after degradation is larger than the polarization $\Delta V$ before degradation. In view of the above, in estimating the degradation amount of the secondary battery 25, the battery management system 1 rewrites the open circuit potential OCP to the closed circuit potential CCP in consideration of the polarization $\Delta V$, and predicts the battery capacity QB using the closed circuit potential CCP.

In step S28, the battery management system 1 calculates the negative electrode capacity $Q_a$, the positive electrode capacity $Q_c$, and the positive-negative electrode SOC deviation capacity $Q_{Li}$ of the secondary battery 25. First, the battery management system 1 acquires the negative electrode side closed circuit potential $CCP_a$ and the positive electrode side closed circuit potential $CCP_c$ calculated in step S27, the battery temperature T of the secondary battery 25 calculated in step S21, and the change amount $\Delta DOD$ calculated in step S23.

Next, the battery management system 1 calculates each of the negative electrode capacity $Q_a$, the positive electrode capacity $Q_c$, and the positive-negative electrode SOC deviation capacity $Q_{Li}$ of the secondary battery 25 on the basis of at least one of the negative electrode side closed circuit potential $CCP_a$ and the positive electrode side closed circuit potential $CCP_c$, the battery temperature T, the current value I, and the change amount $\Delta DOD$.

First, calculation of the negative electrode capacity $Q_a$ will be described. The battery management system 1 expresses the negative electrode capacity $Q_a$ with the same theory as the case of calculating the negative electrode resistance $R_a$. That is, the negative electrode capacity $Q_a$ is expressed by the following formula (12) using a function $i_A$ (T, $CCP_a$), a function $i_B$ (T, $CCP_a$, $\Delta DOD$, I), and a function $i_C$ (T, $CCP_a$, $\Delta DOD$, I).

Here, the function $i_A$ (T, $CCP_a$) is a function considering that a film is formed on the surface of the active material.

The function $i_B$ (T, $CCP_a$, $\Delta DOD$, I) is a function in consideration of cracking of the film formed on the surface of the active material. The function $i_C$ (T, $CCP_a$, $\Delta DOD$, I) is a function in consideration of cracking of the active material itself. That is, the negative electrode capacity $Q_a$ is expressed as a function of the battery temperature T of the secondary battery 25, the negative electrode side closed circuit potential $CCP_a$, the change amount $\Delta DOD$ (i.e., pulverization function f (t, $\Delta DOD$)), and the charge-discharge current value I.

[Mathematical formula 11]

$$Q_a = i_A(T, CCP_a) \times i_B(T, CCP_a, \Delta DOD, I) \times i_C(T, CCP_a, \Delta DOD, I) \qquad (12)$$

Next, calculation of the positive electrode capacity $Q_c$ will be described. The battery management system 1 expresses the positive electrode capacity $Q_c$ with the same theory as the case of calculating the positive electrode resistance $R_c$. That is, the positive electrode capacity Qc is expressed by the following formula (13) using a function $j_A$ (T, $CCP_c$), a function $j_B$ (T, $CCP_c$, $\Delta DOD$, I), and a function $j_C$ (T, $CCP_c$, $\Delta DOD$, I).

Here, the function $j_A$, (T, $CCP_c$) is a function in consideration of the alteration of the surface of the active material. The function $j_B$ (T, $CCP_c$, $\Delta DOD$, I) is a function in consideration of cracking of the altered surface of the active material. The function $j_C$ (T, $CCP_c$, $\Delta DOD$, I) is a function in consideration of cracking of the active material itself. That is, the positive electrode capacity $Q_c$ is expressed as a function of the battery temperature T, the positive electrode side closed circuit potential $CCP_c$, the change amount $\Delta DOD$ (i.e., pulverization function f (t, $\Delta DOD$)), and the charge-discharge current value I.

[Mathematical formula 12]

$$Q_c = j_A(T, CCP_c) \times j_B(T, CCP_c, \Delta DOD, I) \times j_C(T, CCP_c, \Delta DOD, I) \qquad (13)$$

Subsequently, calculation of the positive-negative electrode SOC deviation capacity $Q_{Li}$ will be described. The positive-negative electrode SOC deviation capacity $Q_{Li}$ correlates with consumption of lithium ions due to formation of a film (solid electrolyte interface (SEI)) in the negative electrode and the positive electrode. Since the consumption of lithium ions due to the formation of the film is a chemical reaction, the positive-negative electrode SOC deviation capacity $Q_{Li}$ follows the Arrhenius law. Therefore, the positive-negative electrode SOC deviation capacity $Q_{Li}$ can be expressed by a function of the battery temperature T.

The consumption of lithium ions due to film formation in the negative electrode and the positive electrode follows the Tafel's law since it is an oxidation-reduction reaction. Therefore, the positive-negative electrode SOC deviation capacity $Q_{Li}$ can be expressed by a function of the negative electrode side closed circuit potential $CCP_a$ and the positive electrode side closed circuit potential $CCP_c$.

In addition, expansion and contraction of the active material of each electrode (i.e., positive electrode and negative electrode) are repeated by repetition of the charge-discharge cycle of the secondary battery 25, and cracking of the surface film of the active material in each electrode progresses. As a result, each electrode surface is eventually exposed from the crack of the film, and a new film is formed on the exposed surface, thereby increasing the consumption amount of lithium ions. In addition, the larger the change amount $\Delta DOD$, the larger the degree of expansion and contraction of the active material. Therefore, the positive-negative electrode SOC deviation capacity $Q_{Li}$ can be expressed by a function of the change amount $\Delta DOD$.

In each electrode, as described above, the active material itself cracks and the diameter thereof decreases due to repeated expansion and contraction of the active material. Cracking of the active material itself includes both an element for increasing the positive-negative electrode SOC deviation capacity $Q_{Li}$ and an element for decreasing the positive-negative electrode SOC deviation capacity $Q_{Li}$.

First, since a new surface (i.e., surface on which film is not formed) is formed on the active material due to cracking of the active material itself, lithium ions are more likely to move to the active material of each electrode, which causes an increase in positive-negative electrode SOC deviation capacity $Q_{Li}$. On the other hand, when a new surface is formed on the active material, film formation is promoted on the new surface to consume lithium ions, which causes a decrease in positive-negative electrode SOC deviation capacity $Q_{Li}$.

In consideration of the above, the positive-negative electrode SOC deviation capacity $Q_{Li}$ can be expressed by a formula (i.e., function of change amount $\Delta DOD$) including the pulverization function f (t, $\Delta DOD$) from the same theory as the negative electrode resistance $R_a$ and the positive electrode resistance $R_c$.

Cracking of the active material itself in each electrode also depends on the charge-discharge current value I. As the charge-discharge current value I increases, the current tends to intensively flow through a low resistance portion of the active material, so that the degree of expansion and contraction may vary depending on the portion of the active material. As a result, strain is likely to occur in the active material, which causes cracking of the active material itself. Therefore, the cracking of the active material itself of each electrode can be expressed by a function of the charge-discharge current value I or a function of the C rate correlated with the charge-discharge current value I.

As described above, the positive-negative electrode SOC deviation capacity $Q_{Li}$ is expressed by the following formula (14) using the function $k_A$ (T, $CCP_a$), the function $k_B$ (T, $CCP_a$, $\Delta DOD$, I), $k_C$ (T, $CCP_a$, $\Delta DOD$, I), the function $l_A$ (T, $CCP_c$), the function $l_B$ (T, $CCP_c$, $\Delta DOD$, I), and the function $l_C$ (T, $CCP_c$, $\Delta DOD$, I).

Here, the function $k_A$ (T, $CCP_a$) is a function considering that a film is formed on the surface of the active material of the negative electrode. The function $k_B$ (T, $CCP_a$, $\Delta DOD$, I) is a function in consideration of cracking of the film formed on the surface of the active material of the negative electrode. The function $k_C$ (T, $CCP_a$, $\Delta DOD$, I) is a function in consideration of cracking of the active material itself of the negative electrode.

Further, the function $l_A$ (T, $CCP_c$) is a function considering that a film is formed on the surface of the active material of the positive electrode. The function $l_B$ (T, $CCP_c$, $\Delta DOD$, I) is a function in consideration of cracking of the film formed on the surface of the active material of the positive electrode. The function $l_C$ (T, $CCP_c$, $\Delta DOD$, I) is a function in consideration of cracking of the active material itself of the positive electrode.

[Mathematical formula 13]

$$Q_{Li} = k_A(T, CCP_a) \times k_B(T, CCP_a, \Delta DOD, I) \times k_C(T, CCP_a, \Delta DOD, I)$$
$$+ l_A(T, CCP_c) \times l_B(T, CCP_c, \Delta DOD, I) \times l_C(T, CCP_c, \Delta DOD, I) \quad (14)$$

As described above, the positive-negative electrode SOC deviation capacity $Q_{Li}$ can be expressed as a function of the battery temperature T, the negative electrode side closed circuit potential $CCP_a$, the positive electrode side closed circuit potential $CCP_c$, the change amount $\Delta DOD$, and the charge-discharge current value I.

In step S29, the battery management system 1 obtains the battery capacity $Q_B$ using the negative electrode capacity $Q_a$, the positive electrode capacity $Q_c$, and the positive-negative electrode SOC deviation capacity $Q_{Li}$ calculated in step S28. Specifically, the battery management system 1 determines the smallest one of the negative electrode capacity $Q_a$, the positive electrode capacity $Q_c$, and the positive-negative electrode SOC deviation capacity $Q_{Li}$ of the secondary battery 25 as the battery capacity $Q_B$ of the secondary battery 25. That is, the battery management system 1 executes $Q_B$ = min ($Q_a$, $Q_c$, $Q_{Li}$).

As described above, the negative electrode capacity $Q_a$ corresponds to the number of sites of the negative electrode into which lithium ions can be inserted, and the positive electrode capacity $Q_c$ corresponds to the number of sites of the positive electrode into which lithium ions can be inserted. The positive-negative electrode SOC deviation capacity $Q_{Li}$ corresponds to the number of lithium ions that can move between the positive electrode and the negative electrode and ease of movement of all lithium ions. Therefore, the smallest one of the negative electrode capacity $Q_a$, the positive electrode capacity $Q_c$, and the positive-negative electrode SOC deviation capacity $Q_{Li}$ corresponds to the battery capacity $Q_B$ of the secondary battery 25.

In step S29, the battery management system 1 obtains a battery resistance $R_B$, which is the resistance value of the entire secondary battery 25, using the negative electrode resistance $R_a$ and the positive electrode resistance $R_c$. Specifically, the battery management system 1 determines the sum of the components (negative electrode resistance $R_a$ and positive electrode resistance $R_c$) forming the secondary battery 25 as the resistance value of the entire secondary battery 25. That is, the battery management system 1 executes $R_B$ = $R_a$ + $R_c$.

As described above, each of the negative electrode resistance $R_a$, the positive electrode resistance $R_c$, the negative electrode capacity $Q_a$, the positive electrode capacity $Q_c$, the positive-negative electrode SOC deviation capacity $Q_{Li}$, the battery capacity $Q_B$, and the battery resistance $R_B$ of the secondary battery 25 at the present time is calculated. The battery management system 1 calculates the element degradation states $SOHQ_ae$, $SOHQ_ce$, $SOHQ_{Li}e$, $SOHR_ae$, and $SOHR_ce$ using the calculated positive electrode capacity $Q_c$ and the like.

For example, the element degradation state $SOHQ_ae$ is calculated by obtaining the ratio of the negative electrode capacity $Q_a$ of the secondary battery 25 at the present time to the negative electrode capacity $Q_a$ of the initial secondary battery 25. The element degradation state $SOHQ_ce$ is calculated by obtaining the ratio of the positive electrode capacity $Q_c$ of the secondary battery 25 at the present time to the positive electrode capacity $Q_c$ of the initial secondary battery 25. The element degradation state $SOHQ_{Li}e$ is calculated by obtaining the ratio of the positive-negative electrode SOC deviation capacity $Q_{Li}$ of the secondary battery 25 at the present time to the positive-negative electrode SOC deviation capacity $Q_{Li}$ in the initial secondary battery 25.

The element degradation state $SOHR_ae$ is calculated by obtaining the ratio of the negative electrode resistance $R_a$ of the secondary battery 25 at the present time to the negative electrode resistance $R_a$ in the secondary battery 25 in the initial state. The element degradation state $SOHR_ce$ is calculated by obtaining the ratio of the positive electrode resistance $R_c$ of the secondary battery 25 at the present time to the positive electrode resistance $R_c$ of the secondary battery 25 in the initial state.

In the calculation processing of steps S24 to S29, the constants included in the formulae and the coefficients and constants of the functions forming each formula are determined with reference to the battery characteristic information stored in the battery database 54.

In this case, after completion of the calculation processing of the battery state in step S29, the battery management system 1 compares the calculated degradation state identified by the battery state of the secondary battery 25 with the degradation state actually occurring in the secondary battery 25, and updates the battery characteristic information of the battery database 54.

Specifically, the battery management system 1 updates the battery characteristic information of the battery database 54 such that the state expressed by the battery states $SOHQ_Be$ and $SOHR_Be$ matches the state of degradation actually occurring in the secondary battery 25. The control unit 51 executing this step corresponds to the battery characteristic learning unit 51g.

In this way, by calculating the degradation state of each component of the secondary battery 25 in consideration of a plurality of causes of degradation of each component, it is possible to predict the degradation state of each component of the secondary battery 25 with high accuracy.

This point will be described with reference to FIG. 9 using a specific example. As a specific example, simulation results on the influence of the difference in causes of degradation on the future progress of degradation will be given using two secondary batteries 25 of the same type (hereinafter referred to as first battery and second battery for convenience).

The first battery and the second battery are secondary batteries of the same type. In the graph illustrated FIG. 9, the horizontal axis represents the square root of the number of days, and the vertical axis represents the capacity retention rate of the secondary battery 25. The capacity retention rate of the secondary battery 25 at a predetermined time is a ratio of the capacity of the secondary battery 25 at the predetermined time to the capacity of the secondary battery 25 in the initial state.

In FIG. 9, an experimental result on the first battery is indicated by line L1, and an experimental result on the second battery is indicated by line L2. In each of the results of the first battery and the second battery illustrated in FIG. 9, the positive-negative electrode SOC deviation capacity $Q_{Li}$ is the smallest among the negative electrode capacity $Q_a$, the positive electrode capacity $Q_c$, and the positive-negative electrode SOC deviation capacity $Q_{Li}$. Therefore, in the experimental results of the first battery and the second battery, the battery capacity $Q_B$ = positive-negative electrode SOC deviation capacity $Q_{Li}$.

The secondary battery 25 through which a large current flows for driving an automobile or the like is often used only in a region where the positive-negative electrode SOC deviation capacity $Q_{Li}$ is the smallest among the negative electrode capacity $Q_a$, the positive electrode capacity $Q_c$, and the positive-negative electrode SOC deviation capacity $Q_{Li}$ of the secondary battery 25. That is, in the secondary battery 25 through which a large current flows, the battery capacity $Q_B$ is often the positive-negative electrode SOC deviation capacity $Q_{Li}$.

In the specific example illustrated in FIG. 9, for the first battery, the first battery was exposed to calendar aging under an environment of 45 °C from a state where the capacity retention rate was 100%, and the capacity retention rate was reduced to 92%. The decrease in capacity of the first battery at this time was 7.2% due to film formation on each electrode, 0.4% due to cracking of the film formed on the surface of the active material of each electrode, and 0.4% due to cracking of the active material itself of each electrode.

On the other hand, in the specific example illustrated in FIG. 9, for the second battery, the second battery was exposed to cycle aging under an environment of 45 °C from a state where the capacity retention rate was 100%, and the capacity retention rate was reduced to 92%. The decrease in capacity of the second battery at this time was 4.0% due to film formation on each electrode, 1.6% due to cracking of the film formed on the surface of the active material of each electrode, and 2.4% due to cracking of the active material itself of each electrode.

That is, even in the first battery and the second battery having the same capacity retention rate and positive-negative electrode SOC deviation capacity $Q_{Li}$, it can be seen that the values of the functions forming formula (14) related to the positive-negative electrode SOC deviation capacity $Q_{Li}$ are different between the first battery and the second battery depending on the previous use situation.

The first battery and the second battery having a capacity retention rate of 92% were aged under the same conditions by combining cycle aging and calendar aging. As illustrated in FIG. 9, in the region where the capacity retention rate is 92% or less, the inclination of line L2 indicating the degradation state of the second battery is larger than the inclination of line L1 indicating the degradation state of the first battery. That is, under this condition, it can be seen that the second battery that was exposed to cycle aging first aged faster than the first battery that was exposed to calendar aging first.

As a result, it can be seen that even in the secondary batteries 25 having the same capacity retention rate, the degree of progress of the subsequent degradation of the secondary batteries 25 varies depending on the previous use situation of the secondary batteries 25. In addition, the positive-negative electrode SOC deviation capacity $Q_{Li}$ is calculated on the basis of a function in consideration of film formation on each electrode, a function in consideration of cracking of the film formed on the surface of the active material of each electrode, and a function in consideration of cracking of the active material itself of each electrode, whereby the battery capacity $Q_B$ with high accuracy can be calculated. The same applies to the case where the battery capacity $Q_B$ is the negative electrode capacity $Q_a$ or the positive

electrode capacity $Q_c$.

Each of the negative electrode resistance $R_a$ and the positive electrode resistance $R_c$ is also calculated in consideration of a plurality of causes of degradation. Therefore, the negative electrode resistance $R_a$ and the positive electrode resistance $R_c$ can also be calculated with high accuracy from the same logic as the logic in which the battery capacity $Q_B$ is calculated with high accuracy.

Referring back to FIG. 4, processing after step S5 will be described. In step S5, plural causes of degradation causing the secondary battery 25, which is a target battery, to enter the battery state calculated in step S4 are extracted. Here, the difference between the state of the secondary battery 25 in the initial state and the state of the secondary battery 25 at the present time is referred to as a total degradation amount Z.

The total degradation amount Z includes a calendar degradation amount Za caused by calendar aging, a cycle degradation amount Zb caused by cycle aging, and a degradation amount Zc caused by other causes of degradation. Therefore, the total degradation amount Z is expressed by the following formula (15).

[Mathematical formula 14]

$$Z = Za + Zb + Zc \quad (15)$$

The calendar degradation amount Za is a degradation amount of the secondary battery 25 caused by calendar aging. Calendar aging progresses with the lapse of time regardless of energization to the secondary battery 25, and shows a tendency to further progress by increasing the battery temperature T of the secondary battery 25. In addition, it is considered that calendar aging progresses by forming a film on the surface of the active material.

As described above, since the film is generated by a chemical reaction such as oxidation-reduction decomposition of the electrolytic solution of the secondary battery 25 or the additive thereof, and thus is formed according to the Arrhenius law, the calendar degradation amount Za can be expressed by a function of the battery temperature T. Additionally, since the film formation is caused by oxidation-reduction, the film formation follows the Tafel's law. Therefore, the calendar degradation amount Za can be expressed by a function of the closed circuit potential CCP. As described above, the calendar degradation amount Za can be obtained by a formula (16) using a function in consideration of the formation of the film in formulae (12) to (14) described above.

[Mathematical formula 15]

$$Za = f\big(i_A(T, CCP_a), j_A(T, CCP_c), k_A(T, CCP_a), l_A(T, CCP_c)\big) \quad (16)$$

The cycle degradation amount Zb is a degradation amount of the secondary battery 25 caused by cycle aging. Cycle aging progresses by energization of the secondary battery 25, and tends to further progress by energization in a state where the battery temperature of the secondary battery 25 is low. In addition, it is considered that cycle aging is caused by expansion and contraction of each electrode and the like, and progresses by cracking of the film formed on the surface of the active material.

As described above, the cracking of the surface film progresses as the expansion and contraction of the active material are repeated as the charge-discharge cycle of the secondary battery 25 is repeated. As a result, a new film is formed on the surface exposed from the crack of the film, so that the film amount increases, and thus the degradation further progresses. The larger the change amount $\Delta DOD$, the larger the degree of expansion and contraction of the active material. Therefore, the cycle degradation amount Zb can be expressed by a function of the change amount $\Delta DOD$. As described above, the cycle degradation amount Zb can be obtained by a formula (17) using a function in consideration of cracking of the film formed on the surface of the active material in formulae (12) to (14) described above.

[Mathematical formula 16]

$$Zb = f\big(i_B(T, CCP_a, \Delta DOD, I), j_B(T, CCP_c, \Delta DOD, I), k_B(T, CCP_a, \Delta DOD, I), l_B(T, CCP_c, \Delta DOD, I)\big) \quad (17)$$

As described above, the calendar degradation amount Za and the cycle degradation amount Zb in the total degradation amount Z of the secondary battery 25 at the present time can be obtained from formulae (16) and (17). As a result, with respect to the degradation of the secondary battery 25 at the present time, it is possible to evaluate which one of the calendar aging caused by the formation of the film on the surface of the active material and the cycle aging caused by cracking of the film formed on the surface of the active material strongly affects the degradation.

After extracting the degradation factor of the target battery in step S5, the battery management system 1 proceeds to step S6 and sets the predicted battery load based on one of the future usage modes of the target battery. The predicted battery load includes information having a strong correlation with the use frequency, the charge/discharge current value I, the battery temperature T, the SOC, and the like of the secondary battery 25 in the use mode in which the target battery is assumed in the future.

In the battery management system 1 according to the present embodiment, since the secondary battery 25 which is the target battery is mounted on the vehicle V, the difference in the operation route along which the vehicle V travels affects the load applied to the secondary battery 25 which is the target battery in the future.

Further, when the vehicle V travels, the mode of the accelerator operation or the brake operation by the driver Dr affects the load applied to the target battery in the future. For example, when an accelerator operation is performed so as to accelerate rapidly, a large load is applied to the secondary battery 25.

As described above, the driver data is stored in the driver database 55, and is input from the information terminal 10 of each driver Dr or the vehicle V via the network N or the like. The driver data includes a reservation status, a work status, a vacation schedule, and the like of the driver Dr input from the information terminal 10. The driver data includes traveling characteristics such as a traveling speed and acceleration/deceleration characteristics (such as frequency or magnitude) input from the vehicle V using a GPS or the like. Further, the driver data includes driver characteristics such as driver's license information (such as, whether the driver is a good driver or not), driving history, and grade related to the driver Dr.

Therefore, the battery management system 1 selects one operation route from plural operation routes, and sets a predicted battery load using the selected operation route and driver data of the driver Dr in charge of the operation route. The predicted battery load is determined in units of a predetermined period (such as weekly or monthly) as the scheduled use period. Accordingly, it is possible to accurately set the predicted battery load generated when the vehicle is driven by the driver Dr in charge of the selected operation route (hereinafter, referred to as a target route).

In step S7, the battery management system 1 uses the predicted battery load to calculate each of the predicted element degradation states $SOHQ_ap$, $SOHQ_cp$, $SOHQ_{Li}p$, $SOHR_ap$, and $SOHR_cp$ of the target battery when the vehicle is driven by the driver Dr in charge of the target route.

That is, the battery management system 1 calculates the predicted element degradation states $SOHQ_ap$, $SOHR_ap$ of the negative electrode based on plural deterioration factors of the negative electrode of the secondary battery 25 that is the target battery. Then, the battery management system 1 calculates the predicted element degradation states $SOHQ_cp$, $SOHR_cp$ of the positive electrode based on the plural deterioration factors of the positive electrode in the target battery. The battery management system 1 calculates the predicted element degradation state $SOHQ_{Li}p$ of the electrolyte based on the plural deterioration factors of the electrolyte in the target battery. The deterioration factor of each battery component is the same as the deterioration factor of each battery component in steps S3 to S4 described above.

Subsequently, the battery management system 1 calculates predicted battery states $SOHQ_Bp$, $SOHR_Bp$, which are deterioration states of the entire target battery that will occur in the future when the vehicle is driven by the driver Dr in charge of the target route, using the predicted element degradation state of the target battery.

The predicted battery state SOHQBp is calculated by taking the minimum value of the predicted element degradation states $SOHQ_ap$, $SOHQ_cp$, and $SOHQ_{Li}p$, and indicates the deterioration state related to the capacity of the secondary battery 25 which is the target battery. That is, it can be expressed as $SOHQ_Bp = min(SOHQ_ap, SOHQ_cp, SOHQ_{Li}p)$.

The predicted battery state $SOHR_Bp$ is calculated by the sum of the predicted element degradation states $SOHR_ap$ and $SOHR_cp$, and indicates the deterioration state related to the resistance of the secondary battery 25 that is the target battery. That is, it can be expressed as $SOHR_Bp = SOHR_ap + SOHR_cp$.

In step S8, the battery management system 1 calculates the deterioration change degree $\Delta De$ of the target battery by using the current battery states $SOHQ_Be$ and $SOHR_Be$ of the target battery calculated in step S4 and the predicted battery states $SOHQ_Bp$ and $SOHR_Bp$ calculated in step S7.

The deterioration change degree $\Delta De$ indicates the degree of progress of deterioration that will occur in the target battery in the future when the vehicle is driven by the driver Dr in charge of the target route, and can be said to be a change in the deterioration amount. In the battery management system 1, when the number of types of usage modes (that is, the predicted battery load) including an operation route is defined as x and the number of the secondary batteries 25 serving as target battery is defined as y, the deterioration change degree $\Delta De$ can be expressed as $\Delta De (x, y)$. The calculated deterioration change degree $\Delta De$ is stored in the storage device 53 of the management server 50.

In step S9, the battery management system 1 determines whether or not the calculation of the deterioration change degree $\Delta De$ of the target battery has been completed for all the patterns of the predicted battery loads defined in the battery management system 1. When the calculation of the deterioration change degree $\Delta De$ relating to all patterns of the predicted battery load has been completed for the target battery, the battery management system 1 advances the processing to step S10. When the calculation of the deterioration change degree $\Delta De$ has not been completed, the battery management system 1 returns the process to step S6 and sets the predicted battery load for which the calculation of the deterioration change degree $\Delta De$ has not been completed for the target battery.

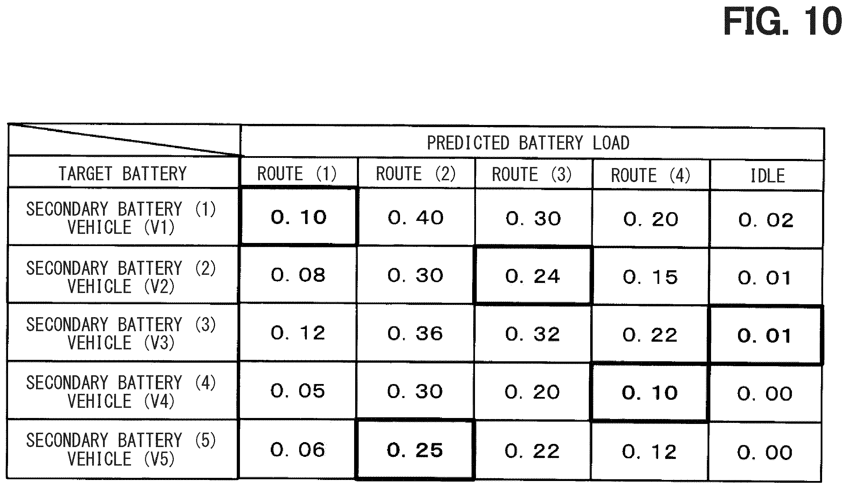

This point will be described based on a specific example illustrated in FIG. 10. In the specific example shown in FIG. 10, there are five secondary batteries (a) to (e) as the target battery 25. The secondary battery (a) is mounted on the vehicle V1. The secondary battery (b) is mounted on the vehicle V2. The secondary battery (c) is mounted on the vehicle V3. The secondary battery (d) is mounted on the vehicle V4. The secondary battery (e) is mounted on the vehicle V5.

In the specific example illustrated in FIG. 10, there are five types of predicted battery loads defined in the battery management system 1, that is, the route (1), the route (2), the route (3), the route (4), and the idle. The route (1) is an operation route associated with the driver Dr1. The route (2) is an operation route associated with the driver Dr2. The route (3) is an operation route associated with the driver Dr3. The route (4) is an operation route associated with the driver Dr4. The "idle" is a predicted battery load indicating a state in which the vehicle equipped with the target battery is not utilized and remains unused.

Therefore, in the case of the specific example illustrated in FIG. 10, in step S9, it is determined whether or not the calculation of the deterioration change degree $\Delta De$ in the five types of predicted battery loads of the route (1), the route (2), the route (3), the route (4), and the idle is completed for the target battery.

In step S10, the battery management system 1 determines whether or not the calculation processing of the deterioration change degree $\Delta De$ for all the secondary batteries 25 belonging to the battery management system 1 as the target battery is completed. When the calculation processing of the deterioration change degree $\Delta De$ for all the secondary batteries 25 has been completed, the battery management system 1 advances the processing to step S11.

When the calculation processing of the deterioration change degree $\Delta De$ for all the secondary batteries 25 is not completed, the battery management system 1 returns the processing to step S1. As a result, a new target battery is selected from the secondary batteries 25 of the battery management system 1, and calculation processing (that is, step S2 to step S9) of the deterioration change degree $\Delta De$ for the target battery is performed.

In the case of the specific example illustrated in FIG. 10, in step S10, it is determined whether or not the calculation of the deterioration change degree $\Delta De$ at the five types of predicted battery loads of the route (1), the route (2), the route (3), the route (4), and the idle is completed for all of the secondary batteries (a) to (e). That is, FIG. 10 shows a state at the time of transition from step S10 to step S11.

In step S11, a recommended pattern relating to the allocation of the secondary battery 25 and the usage mode (that is, the predicted battery load) is extracted using the evaluation function A. In the first embodiment, an evaluation function Aa is employed as the evaluation function A. The evaluation function Aa is a sum of the deterioration change degrees $\Delta De$ in each of the secondary batteries 25 so that the predicted battery loads do not overlap, and is expressed by the following formula (18).

[Mathematical formula 17]

$$Aa = \sum_y \Delta De(x, y) \quad (18)$$

In formula (18), the number of types of predicted battery loads in the battery management system 1 is denoted by x, and the number of secondary batteries 25 to be target battery is denoted by y.

In step S11, the battery management system 1 extracts, as a recommended pattern, a combination of the secondary battery 25 and the predicted battery load for which the evaluation value calculated by the evaluation function Aa expressed by formula (18) is the minimum value. Therefore, it can be said that the recommended pattern is a combination that can most suppress the progress of the deterioration of the secondary battery 25 as a whole of the battery management system 1 when the plural secondary batteries 25 in the battery management system 1 are operated according to the determined predicted battery load (usage).

In the case of the specific example illustrated in FIG. 10, a combination of the secondary battery 25 and the predicted battery load indicated by a thick frame in FIG. 10 is extracted as a recommended pattern. That is, a combination in which the route (1) is associated with the secondary battery (a), the route (3) is associated with the secondary battery (b), the idle is associated with the secondary battery (c), the route (4) is associated with the secondary battery (d), and the route (2) is associated with the secondary battery (e) is a recommended pattern.

In step S12, the battery management system 1 outputs the recommended pattern extracted in step S11. The recommended pattern may be output by being printed on a paper medium via a printer (not illustrated) or displayed on a screen of the information terminal 10 or the like for each driver Dr. When the recommended pattern is output, other information may be output with the recommended pattern. For example, information such as the battery state $SOHQ_Be$, $SOHR_Be$, and the deterioration factor of each secondary battery 25 may be output together with the recommended pattern. After outputting the recommended pattern, the battery management system 1 ends the battery management process.

As described above, according to the battery management system 1 of the first embodiment, in step S8, the deterioration change degree $\Delta De$ is specified using the deterioration state and the deterioration factor of the secondary battery 25 at the present time point and the predicted battery load which is the future usage mode of the secondary battery 25. Therefore, the battery management system 1 can accurately specify the deterioration change degree $\Delta De$ when the predetermined scheduled use period is elapsed.

Then, according to the battery management system 1 of the first embodiment, since the recommended pattern is extracted so that the evaluation value becomes the minimum value using the specified deterioration change degree $\Delta De$, it

is possible to manage each secondary battery 25 and the predicted battery load in a mode in which deterioration of each secondary battery 25 can be suppressed in the entire system.

As shown in formula (18), the evaluation function Aa in the first embodiment is determined by the total value of the deterioration change degrees $\Delta$De in which the secondary battery 25 and the predicted battery load are associated with each other. The recommended pattern in the first embodiment is extracted as a pattern in which each of the secondary batteries 25 and the predicted battery load are associated with each other so that the evaluation value of the evaluation function Aa is minimized.

Accordingly, the battery management system 1 of the first embodiment can manage the secondary battery 25 and the predicted battery load so as to appropriately suppress deterioration of the secondary battery 25 as the entire system.

When the battery load history is acquired in step S2, as shown in FIG. 6, the data in the standing period Pel is estimated and interpolated from the data of the use period Pe constituting the history target period.

Accordingly, the battery management system 1 can reliably acquire the battery load history in the accurate history target period, and thus can accurately specify the deterioration state and the deterioration factor of the secondary battery 25 at the current time point.

In the calculation processing of steps S24 to S29, the constants included in the respective mathematical expressions, the coefficients of the functions constituting the respective mathematical expressions, and the constants are determined with reference to the battery characteristic information stored in the battery database 54.

In this case, after completion of the calculation processing of the battery state in step S29, the battery management system 1 compares the calculated degradation state identified by the battery state of the secondary battery 25 with the degradation state actually occurring in the secondary battery 25, and updates the battery characteristic information of the battery database 54.

As a result, by updating the battery characteristic information at any time, even in a case where the progress of deterioration is affected by the usage mode or the like of the secondary battery 25, it is possible to accurately calculate the element degradation state and the battery state of the secondary battery 25 while suppressing the influence.

Second Embodiment

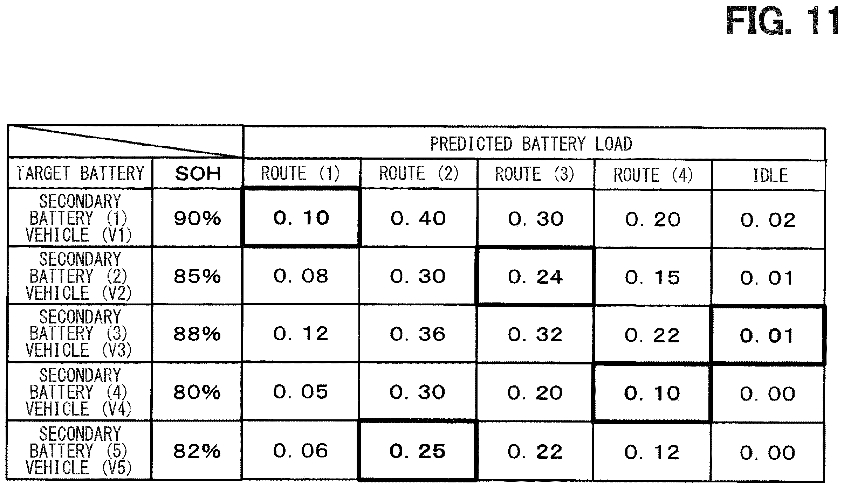

Next, the second embodiment different from the above embodiment will be described with reference to FIG. 11. In the second embodiment, the processing content of step S11 is different from that of the above embodiment. The other basic configurations and the like of the battery management system 1 are the same as those of the above embodiment, and thus the description thereof will not be repeated.

In the battery management system 1 according to the second embodiment, the processes of steps S1 to S10 are executed in the same process as in the first embodiment. As a result, as schematically illustrated in FIG. 11, the storage device 53 of the management server 50 stores data of the deterioration change degree $\Delta$De generated in the secondary battery 25 when the secondary battery is used at the predicted battery load. In the management server 50, the data of the battery states $SOHQ_B$e and $SOHR_B$e of the respective secondary batteries 25 calculated in step S4 is stored in the storage device 53.

Also in step S11 of the second embodiment, the battery management system 1 extracts a recommended pattern related to the allocation of the secondary battery 25 and the usage mode (that is, the predicted battery load) using the evaluation function A. In the second embodiment, an evaluation function Ab is employed as the evaluation function A.

The evaluation function Ab is configured by summing numerical values obtained by multiplying the state of deterioration occurring at the present time in each secondary battery 25 by the deterioration change degree $\Delta$De in each secondary battery 25 so that the predicted battery loads do not overlap, and is expressed by the following formula (19).

[Mathematical formula 18]

$$Ab = \sum_y (m \times (1 - SOH(y)) \times n \times \Delta De(x, y)) \quad (19)$$

In formula (19), the number of types of predicted battery loads in the battery management system 1 is denoted by x, and the number of secondary batteries 25 to be target battery is denoted by y. Further, m is a weighting coefficient related to deterioration of the secondary battery 25 occurring at the present time, and n is a weighting coefficient related to deterioration of the secondary battery 25 occurring in the future according to the predicted battery load.

In step S11 according to the second embodiment, the battery management system 1 extracts, as a recommended pattern, a combination of the secondary battery 25 and the predicted battery load for which the evaluation value calculated by the evaluation function Ab expressed by formula (19) is the minimum value.

In general, since the rate of progress of deterioration is faster when deterioration does not progress, it is possible to restrict a predicted battery load indicating a high load from being allocated to the secondary battery 25 in which deterioration is progressing by considering the deterioration state of the secondary battery 25 at the present time. Accordingly, it is possible to suppress variation in progress of deterioration among the secondary batteries 25 of the battery management system 1.

Therefore, it can be said that the recommended pattern is a combination that can most suppress the progress of the deterioration of the secondary battery 25 as a whole of the battery management system 1 when the secondary batteries 25 in the battery management system 1 are operated according to the determined predicted battery load (usage). In addition, according to the battery management system 1, since it is possible to suppress variation in progress of deterioration among the secondary batteries 25, it is possible to facilitate maintenance management (such as replacement or maintenance) of all the secondary batteries 25.

Step S12 according to the second embodiment is the same as step S12 according to the first embodiment, and thus the description thereof will not be repeated. Thereafter, the battery management system 1 ends the battery management process.

As described above, in the battery management system 1 of the second embodiment, the evaluation function Ab is determined so as to multiply the deterioration state of the secondary battery 25 at the present time by the deterioration change degree ΔDe in which the secondary battery 25 and the predicted battery load are associated with each other, as shown in formula (19). Then, the recommended pattern is extracted as a pattern in which each of the secondary batteries 25 is associated with the predicted battery load so that the evaluation value of the evaluation function Ab is minimized.

As a result, the battery management system 1 according to the second embodiment associates each of the secondary batteries 25 with the predicted battery load in consideration of the deterioration state of the secondary battery 25 at the present time. Thus, it is possible to suppress variation in deterioration among the secondary batteries 25 constituting the system. Therefore, the battery management system 1 can appropriately suppress deterioration of the secondary battery 25 as the entire system, and can manage the secondary battery 25 and the predicted battery load so that maintenance and management can be easily performed.

Third Embodiment

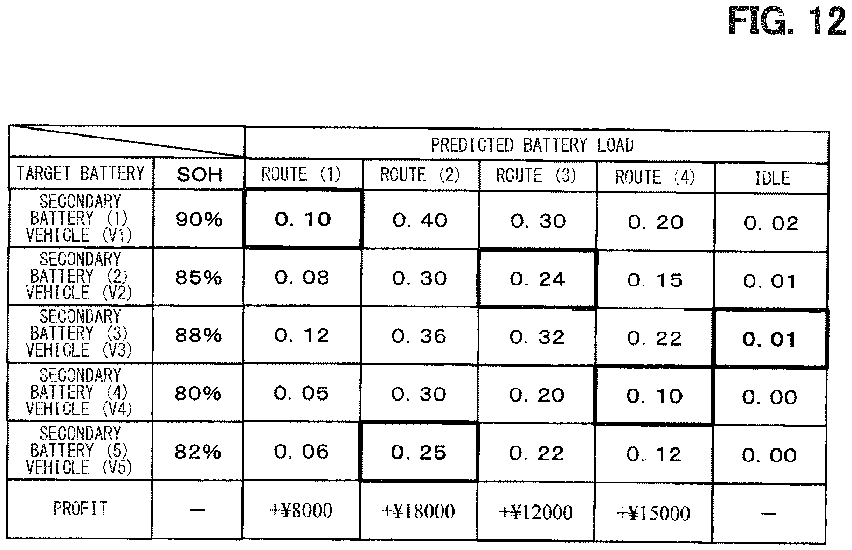

Next, the third embodiment different from the above embodiment will be described with reference to FIG. 12. In the third embodiment, the processing content of step S11 is different from that of the above embodiment. The other basic configurations and the like of the battery management system 1 are the same as those of the above embodiment, and thus the description thereof will not be repeated.

In the battery management system 1 according to the third embodiment, the processes of steps S1 to S10 are executed in the same manner as those in the above embodiment. As a result, as schematically illustrated in FIG. 12, the storage device 53 of the management server 50 stores data of the deterioration change degree ΔDe generated in the secondary battery 25 when the secondary battery is used at the predicted battery load. In the management server 50, the data of the battery states $SOHQ_Be$ and $SOHR_Be$ of the respective secondary batteries 25 calculated in step S4 is stored in the storage device 53.

Also in step S11 in the third embodiment, the battery management system 1 extracts a recommended pattern related to the allocation of the secondary battery 25 and the usage mode (that is, the predicted battery load) using the evaluation function A. In the third embodiment, an evaluation function Ac is employed as the evaluation function A.

The evaluation function Ac is configured by multiplying the state of deterioration of each secondary battery 25 at the present time by the deterioration change degree ΔDe in each secondary battery 25, and adding up the values obtained by dividing the multiplied value by the profit obtained when the secondary battery 25 is at the predicted battery load, so that the predicted battery loads do not overlap. Therefore, the evaluation function Ac is expressed by the following formula (20). [Mathematical formula 19]

$$Ac = \sum_y \left( \frac{m \times (1 - SOH(y) \times n \times \Delta De(x,y))}{g(x)} \right) \quad (20)$$

In formula (20), the number of types of predicted battery loads in the battery management system 1 is denoted by x, and the number of secondary batteries 25 to be target battery is denoted by y. Further, m is a weighting coefficient related to deterioration of the secondary battery 25 occurring at the present time, and n is a weighting coefficient related to deterioration of the secondary battery 25 occurring in the future according to the predicted battery load.

The function g(x) in formula (20) is a relational expression indicating a function for calculating a profit obtained by using the secondary battery 25 at the predicted battery load. The function g(x) is derived using, for example, information related to a specific predicted battery load among various information stored in the driver database 55.

For example, in the case of the function g(x) related to the route (2), the function g(x) can compute the profit (sales amount) included in the driver data of the driver Dr2 in charge of the route (2), using the reservation status, the work status, the vacation schedule, the traveling characteristics, and the like of the driver Dr2. In step S11, the control unit 51 that performs the calculation process related to the function g(x) in formula (20) corresponds to the profit estimation unit 51f.

In step S11 according to the third embodiment, the battery management system 1 extracts, as a recommended pattern, a combination of the secondary battery 25 and the predicted battery load for which the evaluation value calculated by the evaluation function Ac expressed by formula (20) is the minimum value.

Accordingly, it can be said that the recommendation pattern according to the third embodiment is a combination in which an appropriate business profit is obtained in consideration of the deterioration of the secondary battery 25 and the profit obtained by using the secondary battery 25 with respect to the business to which the battery management system 1 is applied. Further, similarly to the above embodiment, it can be said that the recommended pattern is a combination that can most suppress the progress of the deterioration of the secondary battery 25 as a whole of the battery management system 1.

Therefore, the battery management system 1 according to the third embodiment can provide an optimum combination in consideration of the deterioration of the secondary battery 25 and the profit by the use of the secondary battery 25, and can facilitate the maintenance management (such as replacement or maintenance) of all the secondary batteries 25.

Step S12 in the third embodiment is the same as step S12 in the above embodiment, and thus the description thereof will not be repeated. Thereafter, the battery management system 1 ends the battery management process.

In the battery management system 1 according to the third embodiment, the evaluation function Ac is configured by multiplying the deterioration state of each secondary battery 25 at the present time and the deterioration change degree $\Delta De$ in each secondary battery 25, and dividing the value by the profit when the secondary battery 25 is used at the predicted battery load. Then, the recommended pattern is extracted as a pattern in which each of the secondary batteries 25 is associated with the predicted battery load so that the evaluation value of the evaluation function Ac is minimized.

Thereby, the battery management system 1 according to the third embodiment can provide an optimum combination in consideration of the deterioration of the secondary battery 25 and the profit by the use of the secondary battery 25, and can facilitate the maintenance management (such as replacement or maintenance) of all the secondary batteries 25.

Fourth Embodiment

Next, the fourth embodiment different from the above embodiment will be described with reference to FIG. 17. In the fourth embodiment, the processing contents of steps S6 to S11 are different from those of the above embodiment. The other basic configurations and the like of the battery management system 1 are the same as those of the above embodiment, and thus the description thereof will not be repeated.

In the battery management system 1 according to the fourth embodiment, power selling is added to the predicted battery load that can be selected in step S6. The power selling means the use of power selling in which the power stored in the secondary battery 25, which is the target battery, is sold to an external power system (such as an electric power company) via the external connector 29.

In the fourth embodiment, since it is desirable that the vehicle is not traveling in order to perform the power selling use, it can be said that the predicted battery load of the power selling is a variation of the predicted battery load of the idle state. In step S6 of the fourth embodiment, electric power selling may be selected as the predicted battery load.

When the power selling is selected as the predicted battery load, the power stored in the secondary battery 25 is output to the external power system, so that the deterioration of the secondary battery 25 progresses. Therefore, in step S7 of the fourth embodiment, deterioration (predicted battery state) that will occur in the secondary battery 25 in the future due to power selling may be specified.

In step S8 according to the fourth embodiment, the deterioration change degree $\Delta De$ of the secondary battery 25 in the case of being used at the predicted battery load including power selling is calculated. The subsequent steps S9 and S10 are the same as those in the above embodiment.

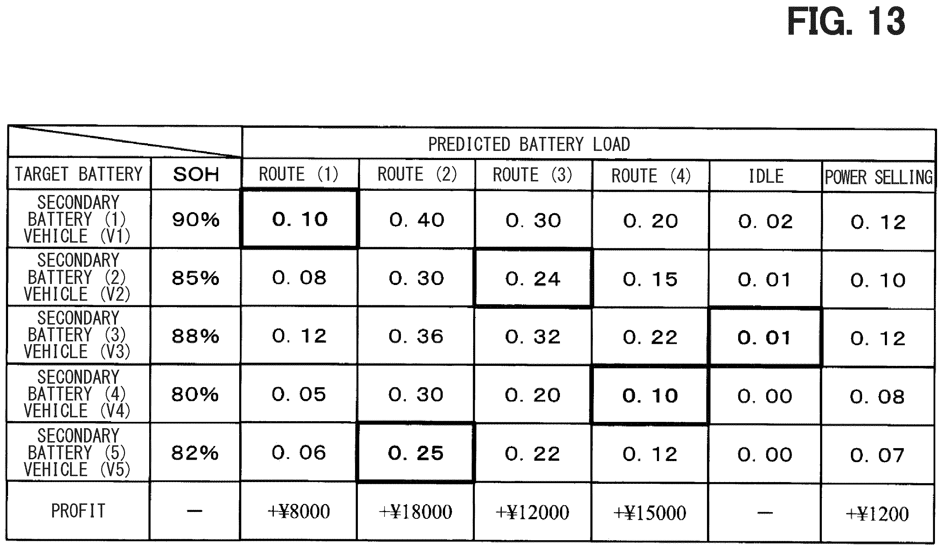

As a result, as schematically illustrated in FIG. 13, the storage device 53 of the management server 50 stores data of the deterioration change degree $\Delta De$ generated in the secondary battery 25 when the secondary battery is used at the predicted battery load. In the management server 50, the data of the battery states $SOHQ_Be$ and $SOHR_Be$ of the respective secondary batteries 25 calculated in step S4 is stored in the storage device 53.

Also in step S11 in the fourth embodiment, the battery management system 1 extracts a recommended pattern related to the allocation of the secondary battery 25 and the usage mode (that is, the predicted battery load) using the evaluation function A. In the fourth embodiment, an evaluation function Ad is adopted as the evaluation function A.

The evaluation function Ad is configured by multiplying the state of deterioration of the secondary battery 25 at the present time by the deterioration change degree $\Delta De$ in the secondary battery 25, dividing the value by the profit obtained when the secondary battery 25 is used with the predicted battery load, and summing the values so that the predicted battery loads do not overlap.

That is, the evaluation function Ad is the same as the evaluation function Ac according to the third embodiment except for the function related to the profit obtained when the secondary battery 25 is used at the predicted battery load. This is because, in the fourth embodiment, the predicted battery load includes the power selling, and thus the function related to the profit is different. The evaluation function Ad is expressed by formula (21).

[Mathematical formula 20]

$$Ad = \sum_y \left( \frac{m \times (1 - SOH(y) \times n \times \Delta De(x,y))}{ga(x)} \right) \quad (21)$$

In formula (21), the number of types of predicted battery loads in the battery management system 1 is denoted by x, and the number of secondary batteries 25 to be target battery is denoted by y. Further, m is a weighting coefficient related to deterioration of the secondary battery 25 occurring at the present time, and n is a weighting coefficient related to deterioration of the secondary battery 25 occurring in the future according to the predicted battery load.

The function ga(x) in formula (21) is a relational expression indicating a function for calculating a profit obtained by using the secondary battery 25 at the predicted battery load. The function ga(x) is different from the function g(x) in that the profit obtained by electric power selling can be calculated. Information such as the unit price of electric power to be sold is used to calculate the profit obtained by electric power selling in the function ga(x). The control unit 51 that performs the calculation process related to the function ga(x) in formula (21) corresponds to the profit estimation unit 51f.

In step S11 according to the fourth embodiment, the battery management system 1 extracts, as a recommended pattern, a combination of the secondary battery 25 and the predicted battery load for which the evaluation value calculated by the evaluation function Ad expressed by formula (21) is the minimum value.

Accordingly, it can be said that the recommendation pattern according to the fourth embodiment is a combination in which an appropriate business profit is obtained in consideration of the deterioration of the secondary battery 25 and the profit obtained by the use of the secondary battery 25 with respect to the business including the power selling use to which the battery management system 1 is applied. Further, similarly to the above embodiment, it can be said that the recommended pattern is a combination that can most suppress the progress of the deterioration of the secondary battery 25 as a whole of the battery management system 1.

Therefore, the battery management system 1 according to the fourth embodiment can provide an optimal combination in consideration of the deterioration of the secondary battery 25 and the profit from the use of the secondary battery 25 including the power selling. In addition, since the battery management system 1 can suppress variation in deterioration among all the secondary batteries 25, it is possible to facilitate maintenance management (such as replacement or maintenance) of all the secondary batteries 25.

Step S12 in the fourth embodiment is the same as step S12 in the above embodiment, and thus the description thereof will not be repeated. Thereafter, the battery management system 1 ends the battery management process.

In the battery management system 1 according to the fourth embodiment, the evaluation function Ad is configured by multiplying the deterioration state of each secondary battery 25 at the present time and the deterioration change degree ΔDe in each secondary battery 25, and dividing the value by the profit when the secondary battery 25 is used at the predicted battery load. Here, the profit in the case of using the secondary battery 25 at the predicted battery load is derived by the function ga(x), and includes the profit in the use of electric power selling for selling the electric power of the secondary battery 25. Then, the recommended pattern is extracted as a pattern in which the secondary battery 25 and the predicted battery load are associated with each other so that the evaluation value of the evaluation function Ad is minimized.

Accordingly, the battery management system 1 of the fourth embodiment can provide an optimum combination in consideration of the deterioration of the secondary battery 25 and the profit by the use of the secondary battery 25 in a mode in consideration of the selling of the power of the secondary battery 25.

In addition, since the battery management system 1 can suppress variation in deterioration among the secondary batteries 25 constituting the system, it is possible to facilitate maintenance management (such as replacement or maintenance) of all the secondary batteries 25.

The present disclosure is not limited to the above embodiments, and can be variously modified as follows without departing from the gist of the present disclosure.

In the embodiments, the vehicle V using the electric power of the secondary battery 25 as the driving source is adopted as a device using the secondary battery 25, and is applied to a business category in which the driver Dr operates the vehicle according to the determined operation route to make a profit, but not limited to this aspect.

If the battery load history can be acquired, various modes can be adopted as the device using the secondary battery 25. The use device of the battery management system 1 is not limited to one type (e.g., vehicle), and plural types of devices can be adopted while the devices can acquire the battery load history.

In addition, the number of secondary batteries 25 included in the battery management system 1 and the type of predicted battery load, which is a future use mode of the secondary battery 25, are not limited to the above embodiments. The number of secondary batteries 25 and the type of the predicted battery load can be appropriately changed according to the calculation load of the deterioration change degree ΔDe and the evaluation value related to the evaluation function A, the performance of the management server 50, and the like.

The battery management system 1 may be configured to execute the following contents as the processing by the battery load acquisition unit 51c (that is, the control unit 51 that executes step S6).

For example, in the battery management system 1,

the battery load acquisition unit includes a usage history learning unit that learns a usage history of the secondary battery when the use device is used in accordance with a use plan in association, the use plan indicating a load variation of the secondary battery when the use device is used, and

the battery load information is acquired using use plan information indicating a use plan of the use device and a learning result by the usage history learning unit.

As a specific example of the above-described configuration, the use device is a vehicle on which a secondary battery is mounted, and the use plan means an operation route on which the vehicle travels. The use plan information is route information indicating an operation route of the vehicle. When the battery load information is acquired with the above-described configuration, information on the ambient temperature of the use device (such as outside air temperature during traveling of the vehicle) may be used in addition to the use plan information and the learning result by the usage history learning unit.

The battery management system 1 may be configured to execute the following processing contents as the processing by the battery load acquisition unit 51c (the control unit 51 that executes step S6).

For example, in the battery management system 1,

the battery load acquisition unit includes a user characteristic learning unit that learns a usage characteristic of a user who uses the use device, and

the battery load information is acquired by using a use schedule status of the user and use characteristic of the user learned by the user characteristic learning unit.

As a specific example of the above-described configuration, the use characteristic of the user is the driving characteristic of the driver, and the use schedule status of the user is the working status or the reservation status of the driver.

In the evaluation function Ac of the third embodiment and the evaluation function Ad of the fourth embodiment, the profit obtained when the secondary battery 25 is used at the predicted battery load is taken into consideration, but other elements may be added to the calculation of the evaluation value. For example, the evaluation function A may be set in consideration of a cost (that is, expenditure) generated in association with charging of the secondary battery 25. In this case, the predicted battery state may be calculated by predicting future deterioration of the secondary battery due to charging of the secondary battery 25.

Further, when the charging of the secondary battery 25 is considered, the predicted battery state or the evaluation value using the evaluation function A may be calculated in consideration of a difference between the normal charging and the quick charging in which the input to the secondary battery 25 is larger than that in the normal charging.

While the present disclosure has been described in accordance with examples, it is understood that the present disclosure is not limited to the examples and structures. The present disclosure also includes various modifications and examples within an equivalent range.

**Claims**

1. A battery management system configured to manage secondary batteries (25) used in a use device (V), comprising:

a usage history acquisition unit (51a) configured to acquire usage history information indicating usage history of the secondary batteries, during a period, mounted on the use device, wherein the usage history acquisition unit is configured to estimate and complement a state of the secondary battery in a standing period (Pel) in which input and output are not performed to and from the secondary battery using a state of the secondary battery in a use period (Pe) in which input and output are performed to and from the secondary battery, so as to acquire the usage history information of the secondary battery in a history target period including the use period and the standing period;

a deterioration estimation unit (51b) configured to estimate current deterioration state of the secondary batteries and a deterioration factor causing the current deterioration state based on the usage history information acquired by the usage history acquisition unit;

a battery load acquisition unit (51c) configured to acquire battery load information indicating a battery load estimated to be applied to the secondary batteries when a predetermined scheduled use period is elapsed in a future, the battery load information being calculated using a future use mode of the secondary batteries in the use device;

a deterioration change degree identification unit (51d) configured to identify a deterioration change degree indicating a change in the deterioration state of the secondary batteries at a time point when the predetermined scheduled use period is elapsed, using the current deterioration state and the deterioration factor estimated by the deterioration estimation unit and the battery load information of the secondary batteries acquired by the battery load acquisition unit; and

a battery management unit (51e) configured to associate the secondary batteries with a plurality of future use modes by using the deterioration change degree of the secondary batteries identified by the deterioration change degree identification unit such that an evaluation value becomes a minimum value, the evaluation value indicating a degree of deterioration of the secondary batteries in a plurality of the use devices.

2. The battery management system according to claim 1, wherein

the battery management unit is configured to specify the evaluation value according to an evaluation function (Aa) determined by a total value of the deterioration change degree ($\Delta De$) in a case where the secondary batteries and the future usage modes in the use devices are associated with each other, and

the battery management unit is configured to associate the secondary batteries with the future use modes such that the evaluation value is minimized.

3. A battery management system configured to manage secondary batteries (25) used in a use device (V), comprising:

a usage history acquisition unit (51a) configured to acquire usage history information indicating usage history of the secondary batteries, during a period, mounted on the use device;

a deterioration estimation unit (51b) configured to estimate current deterioration state of the secondary batteries and a deterioration factor causing the current deterioration state based on the usage history information acquired by the usage history acquisition unit;

a battery load acquisition unit (51c) configured to acquire battery load information indicating a battery load estimated to be applied to the secondary batteries when a predetermined scheduled use period is elapsed in a future, the battery load information being calculated using a future use mode of the secondary batteries in the use device;

a deterioration change degree identification unit (51d) configured to identify a deterioration change degree indicating a change in the deterioration state of the secondary batteries at a time point when the predetermined scheduled use period is elapsed, using the current deterioration state and the deterioration factor estimated by the deterioration estimation unit and the battery load information of the secondary batteries acquired by the battery load acquisition unit; and

a battery management unit (51e) configured to associate the secondary batteries with a plurality of future use modes by using the deterioration change degree of the secondary batteries identified by the deterioration change degree identification unit such that an evaluation value becomes a minimum value, the evaluation value indicating a degree of deterioration of the secondary batteries in a plurality of the use devices, wherein the battery management unit is configured to specify the evaluation value according to an evaluation function (Ab) determined using the deterioration change degree ($\Delta De$) in a case where the secondary batteries and the future usage modes in the use devices are associated with each other and the deterioration state of the secondary batteries in the use devices,

the battery management unit is configured to associate the secondary batteries with the future use modes such that the evaluation value is minimized, the battery management unit includes a profit estimation unit (51f) that is configured to estimate a profit obtained in the future usage mode of the secondary battery associated with the use device,

the evaluation function (Ac, Ad) further includes a relational expression (g(x), ga(x)) between the profit estimated by the profit estimation unit and the deterioration change degree, and

the battery management unit is configured to associate the secondary batteries with the future use modes such that the evaluation value specified according to the evaluation function is minimized.

4. The battery management system according to claim 3, wherein

the future usage mode includes a selling of electric power in which electric power of the secondary battery is used in an electric power system different from the use device,

the profit estimation unit is configured to estimate the profit obtained in a case where the secondary battery is used for the selling of electric power in the use device, and

the deterioration change degree identification unit is configured to identify the deterioration change degree generated when the secondary battery is used for the selling of electric power in the use device.

5. The battery management system according to any one of claims 1 to 4, further comprising: a battery characteristic learning unit (51g) configured to learn battery characteristic information indicating a characteristic related to progress of deterioration of the secondary battery by using the current deterioration state of the secondary battery estimated by the deterioration estimation unit and a state of deterioration actually occurring in the secondary battery, wherein the deterioration estimation unit is configured to estimate the deterioration state and the deterioration factor of the secondary battery using the battery characteristic information learned by the battery characteristic learning unit and the usage history information of the secondary battery acquired by the usage history acquisition unit.

**Patentansprüche**

1. Batterieverwaltungssystem, das dazu eingerichtet ist, Sekundärbatterien (25) zu verwalten, die in einer Verwendungsvorrichtung (V) verwendet werden, umfassend:

eine Verwendungsverlaufserfassungseinheit (51a), die dazu eingerichtet ist, Verwendungsverlaufsinformationen zu erfassen, die einen Verwendungsverlauf der Sekundärbatterien während eines Zeitraums angeben, in dem die Sekundärbatterien in der Verwendungsvorrichtung montiert sind, wobei die Verwendungsverlaufserfassungseinheit dazu eingerichtet ist, einen Zustand der Sekundärbatterie in einem Standzeitraum (Pel), in dem keine Eingabe und keine Ausgabe zu und von der Sekundärbatterie durchgeführt werden, unter Verwendung eines Zustands der Sekundärbatterie in einem Verwendungszeitraum (Pe), in dem eine Eingabe und eine Ausgabe zu und von der Sekundärbatterie durchgeführt werden, abzuschätzen und zu ergänzen, um die Verwendungsverlaufsinformationen der Sekundärbatterie in einem Verlaufszielzeitraum zu erfassen, der den Verwendungszeitraum und den Standzeitraum enthält;

eine Verschlechterungsabschätzungseinheit (51b), die dazu eingerichtet ist, einen aktuellen Verschlechterungszustand der Sekundärbatterien und einen Verschlechterungsfaktor, der den aktuellen Verschlechterungszustand verursacht, basierend auf den von der Verwendungsverlaufserfassungseinheit erfassten Verwendungsverlaufsinformationen abzuschätzen;

eine Batterielasterfassungseinheit (51c), die dazu eingerichtet ist, Batterielastinformationen zu erfassen, die eine Batterielast angeben, von der geschätzt wird, dass sie an die Sekundärbatterien angelegt wird, wenn ein vorbestimmter geplanter Verwendungszeitraum in der Zukunft abgelaufen ist, wobei die Batterielastinformationen unter Verwendung eines zukünftigen Verwendungsmodus der Sekundärbatterien in der Verwendungsvorrichtung berechnet werden;

eine Verschlechterungsänderungsgrad-Identifizierungseinheit (51d), die dazu eingerichtet ist, einen Verschlechterungsänderungsgrad, der eine Änderung des Verschlechterungszustands der Sekundärbatterien zu einem Zeitpunkt angibt, zu dem der vorbestimmte geplante Verwendungszeitraum abgelaufen ist, unter Verwendung des von der Verschlechterungsabschätzungseinheit abgeschätzten aktuellen Verschlechterungszustands und Verschlechterungsfaktors sowie der von der Batterielasterfassungseinheit erfassten Batterielastinformationen der Sekundärbatterien zu identifizieren; und

eine Batterieverwaltungseinheit (51e), die dazu eingerichtet ist, die Sekundärbatterien mit einer Vielzahl zukünftiger Verwendungsmodi unter Verwendung des von der Verschlechterungsänderungsgrad-Identifizierungseinheit identifizierten Verschlechterungsänderungsgrads der Sekundärbatterien derart zu verknüpfen, dass ein Bewertungswert einen Minimalwert annimmt, wobei der Bewertungswert einen Grad der Verschlechterung der Sekundärbatterien in einer Vielzahl von Verwendungsvorrichtungen angibt.

2. Batterieverwaltungssystem nach Anspruch **1**, wobei

die Batterieverwaltungseinheit dazu eingerichtet ist, den Bewertungswert gemäß einer Bewertungsfunktion (Aa) zu spezifizieren, die durch einen Gesamtwert des Verschlechterungsänderungsgrads (∆De) bestimmt wird, in einem Fall, in dem die Sekundärbatterien und die zukünftigen Verwendungsmodi in den Verwendungsvorrichtungen miteinander verknüpft sind, und

die Batterieverwaltungseinheit dazu eingerichtet ist, die Sekundärbatterien mit den zukünftigen Verwendungsmodi derart zu verknüpfen, dass der Bewertungswert minimiert wird.

3. Batterieverwaltungssystem, das dazu eingerichtet ist, Sekundärbatterien (25) zu verwalten, die in einer Verwendungsvorrichtung (V) verwendet werden, umfassend:

eine Verwendungsverlaufserfassungseinheit (51a), die dazu eingerichtet ist, Verwendungsverlaufsinformationen zu erfassen, die einen Verwendungsverlauf der Sekundärbatterien während eines Zeitraums angeben, in dem die Sekundärbatterien in der Verwendungsvorrichtung montiert sind;

eine Verschlechterungsabschätzungseinheit (51b), die dazu eingerichtet ist, einen aktuellen Verschlechterungszustand der Sekundärbatterien und einen Verschlechterungsfaktor, der den aktuellen Verschlechterungszustand verursacht, basierend auf den von der Verwendungsverlaufserfassungseinheit erfassten Verwendungsverlaufsinformationen abzuschätzen;

eine Batterielasterfassungseinheit (51c), die dazu eingerichtet ist, Batterielastinformationen zu erfassen, die eine Batterielast angeben, von der geschätzt wird, dass sie an die Sekundärbatterien angelegt wird, wenn ein vorbestimmter geplanter Verwendungszeitraum in der Zukunft abgelaufen ist, wobei die Batterielastinformationen unter Verwendung eines zukünftigen Verwendungsmodus der Sekundärbatterien in der Verwendungsvorrichtung berechnet werden;

eine Verschlechterungsänderungsgrad-Identifizierungseinheit (51d), die dazu eingerichtet ist, einen Verschlechterungsänderungsgrad, der eine Änderung des Verschlechterungszustands der Sekundärbatterien zu einem Zeitpunkt angibt, zu dem der vorbestimmte geplante Verwendungszeitraum abgelaufen ist, unter Verwendung des von der Verschlechterungsabschätzungseinheit abgeschätzten aktuellen Verschlechterungszustands und Verschlechterungsfaktors sowie der von der Batterielasterfassungseinheit erfassten Batterielastinformationen der Sekundärbatterien zu identifizieren; und

eine Batterieverwaltungseinheit (51e), die dazu eingerichtet ist, die Sekundärbatterien mit einer Vielzahl zukünftiger Verwendungsmodi unter Verwendung des von der Verschlechterungsänderungsgrad-Identifizierungseinheit identifizierten Verschlechterungsänderungsgrads der Sekundärbatterien derart zu verknüpfen, dass ein Bewertungswert einen Minimalwert annimmt, wobei der Bewertungswert einen Grad der Verschlechterung der Sekundärbatterien in einer Vielzahl von Verwendungsvorrichtungen angibt, wobei die Batterieverwaltungseinheit dazu eingerichtet ist, den Bewertungswert gemäß einer Bewertungsfunktion (Ab) zu spezifizieren, die unter Verwendung des Verschlechterungsänderungsgrads ($\Delta De$) und des Verschlechterungszustands der Sekundärbatterien in den Verwendungsvorrichtungen bestimmt wird, in einem Fall, in dem die Sekundärbatterien und die zukünftigen Verwendungsmodi in den Verwendungsvorrichtungen miteinander verknüpft sind,

wobei die Batterieverwaltungseinheit dazu eingerichtet ist, die Sekundärbatterien mit den zukünftigen Verwendungsmodi derart zu verknüpfen, dass der Bewertungswert minimiert wird, wobei die Batterieverwaltungseinheit eine Gewinnabschätzungseinheit (51f) enthält, die dazu eingerichtet ist, einen Gewinn abzuschätzen, der in dem zukünftigen Verwendungsmodus der Sekundärbatterie, die mit der Verwendungsvorrichtung verknüpft ist, erzielt wird,

wobei die Bewertungsfunktion (Ac, Ad) ferner einen Relationsausdruck (g(x), ga(x)) zwischen dem von der Gewinnabschätzungseinheit abgeschätzten Gewinn und dem Verschlechterungsänderungsgrad enthält, und

wobei die Batterieverwaltungseinheit dazu eingerichtet ist, die Sekundärbatterien mit den zukünftigen Verwendungsmodi derart zu verknüpfen, dass der gemäß der Bewertungsfunktion spezifizierte Bewertungswert minimiert wird.

4. Batterieverwaltungssystem nach Anspruch 3, wobei

der zukünftige Verwendungsmodus einen Verkauf elektrischer Energie enthält, bei dem elektrische Energie der Sekundärbatterie in einem von der Verwendungsvorrichtung verschiedenen elektrischen Energiesystem verwendet wird,

die Gewinnabschätzungseinheit dazu eingerichtet ist, den Gewinn abzuschätzen, der in einem Fall erzielt wird, in dem die Sekundärbatterie für den Verkauf elektrischer Energie in der Verwendungsvorrichtung verwendet wird, und

die Verschlechterungsänderungsgrad-Identifizierungseinheit dazu eingerichtet ist, den Verschlechterungsänderungsgrad zu identifizieren, der erzeugt wird, wenn die Sekundärbatterie für den Verkauf elektrischer Energie in der Verwendungsvorrichtung verwendet wird.

5. Batterieverwaltungssystem nach einem der Ansprüche 1 bis 4, ferner umfassend:

eine Batterieeigenschafts-Lerneinheit (51g), die dazu eingerichtet ist, Batterieeigenschaftsinformationen, die eine Eigenschaft in Bezug auf einen Fortschritt der Verschlechterung der Sekundärbatterie angeben, unter Verwendung des von der Verschlechterungsabschätzungseinheit abgeschätzten aktuellen Verschlechterungszustands der Sekundärbatterie und eines tatsächlich in der Sekundärbatterie auftretenden Verschlechterungszustands, zu lernen,

wobei die Verschlechterungsabschätzungseinheit dazu eingerichtet ist, den Verschlechterungszustand und den Verschlechterungsfaktor der Sekundärbatterie unter Verwendung der von der Batterieeigenschafts-Lerneinheit gelernten Batterieeigenschaftsinformationen und der von der Verwendungsverlaufserfassungseinheit erfassten Verwendungsverlaufsinformationen der Sekundärbatterie abzuschätzen.

**Revendications**

1. Système de gestion de batterie configuré pour gérer des batteries secondaires (25) utilisées dans un dispositif d'utilisation (V), comprenant :

   une unité d'acquisition d'historique d'utilisation (51a) configurée pour acquérir des informations d'historique d'utilisation indiquant l'historique d'utilisation, pendant une période, des batteries secondaires montées sur le dispositif d'utilisation, l'unité d'acquisition d'historique d'utilisation étant configurée pour estimer et compléter un état de la batterie secondaire pendant une période de repos (Pel) au cours de laquelle aucune entrée ni sortie n'est réalisée vers et depuis la batterie secondaire, au moyen d'un état de la batterie secondaire pendant une période d'utilisation (Pe) au cours de laquelle des entrée et sorties sont effectuées vers et depuis la batterie secondaire, afin d'acquérir les informations d'historique d'utilisation de la batterie secondaire au cours d'une période cible d'historique comprenant la période d'utilisation et la période de repos ;

   une unité d'estimation de détérioration (51b) configurée pour estimer l'état de détérioration courant des batteries secondaires et un facteur de détérioration provoquant l'état de détérioration courant à partir des informations d'historique d'utilisation acquises par l'unité d'acquisition d'historique d'utilisation ;

   une unité d'acquisition de charge de batterie (51c) configurée pour acquérir des informations de charge de batterie indiquant une charge de batterie estimée à appliquer aux batteries secondaires lorsqu'une période d'utilisation planifiée prédéterminée est écoulée dans un futur, les informations de charge de batterie étant calculées à l'aide d'un mode d'utilisation futur des batteries secondaires dans le dispositif d'utilisation ;

   une unité d'identification de degré de changement de détérioration (51d) configurée pour identifier un degré de changement de détérioration indiquant un changement dans l'état de détérioration des batteries secondaires à un moment où la période d'utilisation programmée prédéterminée est écoulée, en utilisant l'état de détérioration actuel et le facteur de détérioration estimé par l'unité d'estimation de détérioration et les informations de charge de batterie des batteries secondaires acquises par l'unité d'acquisition de charge de batterie ; et

   une unité de gestion de batterie (51e) configurée pour associer les batteries secondaires à une pluralité de modes d'utilisation futurs en utilisant le degré de changement de détérioration des batteries secondaires identifié par l'unité d'identification de degré de changement de détérioration de sorte qu'une valeur d'évaluation devienne une valeur minimale, la valeur d'évaluation indiquant un degré de détérioration des batteries secondaires dans une pluralité de dispositifs d'utilisation.

2. Système de gestion de batterie selon la revendication 1, dans lequel

   l'unité de gestion de batterie est configurée pour spécifier la valeur d'évaluation en fonction d'une fonction d'évaluation (Aa) déterminée par une valeur totale du degré de changement de détérioration ($\Delta De$) dans le cas où les batteries secondaires et les modes d'utilisation futurs dans les dispositifs d'utilisation sont associés les uns aux autres, et

   l'unité de gestion de batterie est configurée pour associer les batteries secondaires aux modes d'utilisation futurs de sorte que la valeur d'évaluation soit réduite au minimum.

3. Système de gestion de batterie configuré pour gérer des batteries secondaires (25) utilisées dans un dispositif d'utilisation (V), comprenant :

   une unité d'acquisition d'historique d'utilisation (51a) configurée pour acquérir des informations d'historique d'utilisation indiquant l'historique d'utilisation, pendant une période, des batteries secondaires montées sur le dispositif d'utilisation ;

   une unité d'estimation de détérioration (51b) configurée pour estimer l'état de détérioration courant des batteries secondaires et un facteur de détérioration provoquant l'état de détérioration courant à partir des informations d'historique d'utilisation acquises par l'unité d'acquisition d'historique d'utilisation ;

une unité d'acquisition de charge de batterie (51c) configurée pour acquérir des informations de charge de batterie indiquant une charge de batterie estimée à appliquer aux batteries secondaires lorsqu'une période d'utilisation planifiée prédéterminée est écoulée dans un futur, les informations de charge de batterie étant calculées à l'aide d'un mode d'utilisation futur des batteries secondaires dans le dispositif d'utilisation ;

une unité d'identification de degré de changement de détérioration (51d) configurée pour identifier un degré de changement de détérioration indiquant un changement dans l'état de détérioration des batteries secondaires à un moment où la période d'utilisation programmée prédéterminée est écoulée, en utilisant l'état de détérioration actuel et le facteur de détérioration estimé par l'unité d'estimation de détérioration et les informations de charge de batterie des batteries secondaires acquises par l'unité d'acquisition de charge de batterie ; et

une unité de gestion de batterie (51e) configurée pour associer les batteries secondaires à une pluralité de modes d'utilisation futurs en utilisant le degré de changement de détérioration des batteries secondaires identifié par l'unité d'identification de degré de changement de détérioration de sorte qu'une valeur d'évaluation devienne une valeur minimale, la valeur d'évaluation indiquant un degré de détérioration des batteries secondaires dans une pluralité de dispositifs d'utilisation, l'unité de gestion de batterie étant configurée pour spécifier la valeur d'évaluation en fonction d'une fonction d'évaluation (Ab) déterminée à l'aide du degré de changement de détérioration (ΔDe) dans un cas où les batteries secondaires et les modes d'utilisation futurs dans les dispositifs d'utilisation sont associés les uns aux autres et de l'état de détérioration des batteries secondaires dans les dispositifs d'utilisation,

l'unité de gestion de batterie est configurée pour associer les batteries secondaires aux modes d'utilisation futurs de telle sorte que la valeur d'évaluation soit minimisée, l'unité de gestion de batterie comprend une unité d'estimation de profit (51f) qui est configurée pour estimer un profit obtenu dans le mode d'utilisation futur de la batterie secondaire associée au dispositif d'utilisation, la fonction d'évaluation (Ac, Ad) comprend en outre une expression relationnelle (g(x), ga(x)) entre le profit estimé par l'unité d'estimation de profit et le degré de changement de détérioration, et

l'unité de gestion de batterie est configurée pour associer les batteries secondaires aux modes d'utilisation futurs de sorte que la valeur d'évaluation spécifiée en fonction de la fonction d'évaluation soit réduite au minimum.

4. Système de gestion de batterie selon la revendication 3, dans lequel

le mode d'utilisation futur comprend une vente d'énergie électrique dans laquelle l'énergie électrique de la batterie secondaire est utilisée dans un système d'énergie électrique différent du dispositif d'utilisation,
l'unité d'estimation de profit est configurée pour estimer le profit obtenu dans un cas où la batterie secondaire est utilisée pour la vente d'énergie électrique dans le dispositif d'utilisation, et
l'unité d'identification du degré de changement de détérioration est configurée pour identifier le degré de changement de détérioration généré lorsque la batterie secondaire est utilisée pour la vente d'énergie électrique dans le dispositif d'utilisation.

5. Système de gestion de batterie selon l'une quelconque des revendications 1 à 4, comprenant en outre : une unité d'apprentissage de caractéristique de batterie (51g) configurée pour apprendre des informations de caractéristique de batterie indiquant une caractéristique liée à la progression de la détérioration de la batterie secondaire en utilisant l'état de détérioration actuel de la batterie secondaire estimé par l'unité d'estimation de détérioration et un état de détérioration se produisant réellement dans la batterie secondaire,

l'unité d'estimation de détérioration étant configurée pour estimer l'état de détérioration et le facteur de détérioration de la batterie secondaire en utilisant les informations caractéristique de la batterie apprises par l'unité d'apprentissage de caractéristique de la batterie et les informations d'historique d'utilisation de la batterie secondaire acquises par l'unité d'acquisition d'historique d'utilisation.

FIG. 1

EP 4 300 758 B1

# FIG. 2

BASE STATION — 5

N

VEHICLE V1(V)

MOTOR GENERATOR — 20
ROTATION SPEED SENSOR — 21
TORQUE SENSOR — 22
TEMPERATURE SENSOR — 23

COMMUNI-CATION TERMINAL — 34

MOTOR CONTROL UNIT — 24

SECONDARY BATTERY — 25
VOLTAGE SENSOR — 26
CURRENT SENSOR — 27
BATTERY TEMPERATURE SENSOR — 28

BATTERY CONTROL UNIT — 30

EXTERNAL CONNECTOR — 29

VEHICLE CONTROL UNIT — 33

ACCELERATOR PEDAL SENSOR — 31
BRAKE PEDAL SENSOR — 32

# FIG. 3

MANAGEMENT SERVER  50

CONTROL UNIT  51

51a    51b    51c    51d

51e    51f    51g

52

COMMUNI-CATION

MEMORY

BATTERY DB

DRIVER DB    55

53    54

N

# FIG. 4

```
        ┌─────────────┐
        │    START    │
        └──────┬──────┘
               │
    ┌──────────▼──────────────┐
    │  SELECT TARGET BATTERY  │──S1
    └──────────┬──────────────┘
               │
    ┌──────────▼──────────────────┐
    │ ACQUIRE BATTERY LOAD HISTORY │──S2
    └──────────┬──────────────────┘
               │
    ┌──────────▼──────────────────┐
    │        CALCULATE             │──S3
    │  ELEMENT DEGRADATION STATE   │
    └──────────┬──────────────────┘
               │
    ┌──────────▼──────────────┐
    │  CALCULATE BATTERY STATE │──S4
    └──────────┬──────────────┘
               │
    ┌──────────▼──────────────────┐
    │ EXTRACT CAUSE OF DEGRADATION │──S5
    └──────────┬──────────────────┘
               │
    ┌──────────▼──────────────────┐
    │  SET PREDICTED BATTERY LOAD  │──S6
    └──────────┬──────────────────┘
               │
    ┌──────────▼──────────────────┐
    │        CALCULATE             │──S7
    │  PREDICTED BATTERY STATE     │
    └──────────┬──────────────────┘
               │
    ┌──────────▼──────────────────┐
    │  CALCULATE DETERIORATION     │──S8
    │      CHANGE DEGREE           │
    └──────────┬──────────────────┘
               │          S9
          ╱────▼────╲        NO
         ╱ COMPLETED  ╲──────────►
         ╲FOR ALL     ╱
          ╲PATTERNS? ╱
               │ YES
               │          S10
          ╱────▼────╲        NO
         ╱IS PROCESSING╲──────────►
         ╲COMPLETED FOR╱
         ╲ALL TARGET   ╱
          ╲BATTERIES? ╱
               │ YES
    ┌──────────▼──────────────────┐
    │ EXTRACT RECOMMENDED PATTERN  │──S11
    │  USING EVALUATION FUNCTION   │
    └──────────┬──────────────────┘
               │
    ┌──────────▼──────────────────┐
    │ OUTPUT RECOMMENDED PATTERN   │──S12
    └──────────┬──────────────────┘
               │
        ┌──────▼──────┐
        │    RETURN   │
        └─────────────┘
```

# FIG. 5

```
        ┌─────────────┐
        │    START    │
        └──────┬──────┘
               │
   ┌───────────────────────┐
   │  ACQUIRE Time, I, T    │──── S21
   └───────────┬───────────┘
               │
   ┌───────────────────────┐
   │     CALCULATE SOC      │──── S22
   └───────────┬───────────┘
               │
   ┌───────────────────────┐
   │    CALCULATE △DOD      │──── S23
   └───────────┬───────────┘
               │
   ┌───────────────────────┐
   │     ACQUIRE Ra, Rc     │──── S24
   └───────────┬───────────┘
               │
   ┌───────────────────────┐
   │  CALCULATE △Va, △Vc    │──── S25
   └───────────┬───────────┘
               │
   ┌───────────────────────┐
   │ CALCULATE OCPa, OCPc   │──── S26
   └───────────┬───────────┘
               │
   ┌───────────────────────┐
   │ CALCULATE CCPa, CCPc   │──── S27
   └───────────┬───────────┘
               │
   ┌───────────────────────┐
   │ CALCULATE Qa, Qc, Q_Li │──── S28
   └───────────┬───────────┘
               │
   ┌───────────────────────┐
   │  CALCULATE Q_B, R_B    │──── S29
   └───────────┬───────────┘
               ▼
        ┌─────────────┐
        │   RETURN    │
        └─────────────┘
```

# FIG. 6

# FIG. 7

# FIG. 8

# FIG. 9

# FIG. 10

| | PREDICTED BATTERY LOAD | | | | |
|---|---|---|---|---|---|
| TARGET BATTERY | ROUTE (1) | ROUTE (2) | ROUTE (3) | ROUTE (4) | IDLE |
| SECONDARY BATTERY (1) VEHICLE (V1) | 0. 10 | 0. 40 | 0. 30 | 0. 20 | 0. 02 |
| SECONDARY BATTERY (2) VEHICLE (V2) | 0. 08 | 0. 30 | 0. 24 | 0. 15 | 0. 01 |
| SECONDARY BATTERY (3) VEHICLE (V3) | 0. 12 | 0. 36 | 0. 32 | 0. 22 | 0. 01 |
| SECONDARY BATTERY (4) VEHICLE (V4) | 0. 05 | 0. 30 | 0. 20 | 0. 10 | 0. 00 |
| SECONDARY BATTERY (5) VEHICLE (V5) | 0. 06 | 0. 25 | 0. 22 | 0. 12 | 0. 00 |

# FIG. 11

| | | PREDICTED BATTERY LOAD | | | | |
|---|---|---|---|---|---|---|
| TARGET BATTERY | SOH | ROUTE (1) | ROUTE (2) | ROUTE (3) | ROUTE (4) | IDLE |
| SECONDARY BATTERY (1) VEHICLE (V1) | 90% | 0. 10 | 0. 40 | 0. 30 | 0. 20 | 0. 02 |
| SECONDARY BATTERY (2) VEHICLE (V2) | 85% | 0. 08 | 0. 30 | 0. 24 | 0. 15 | 0. 01 |
| SECONDARY BATTERY (3) VEHICLE (V3) | 88% | 0. 12 | 0. 36 | 0. 32 | 0. 22 | 0. 01 |
| SECONDARY BATTERY (4) VEHICLE (V4) | 80% | 0. 05 | 0. 30 | 0. 20 | 0. 10 | 0. 00 |
| SECONDARY BATTERY (5) VEHICLE (V5) | 82% | 0. 06 | 0. 25 | 0. 22 | 0. 12 | 0. 00 |

EP 4 300 758 B1

# FIG. 12

| TARGET BATTERY | SOH | PREDICTED BATTERY LOAD | | | | |
|---|---|---|---|---|---|---|
| | | ROUTE (1) | ROUTE (2) | ROUTE (3) | ROUTE (4) | IDLE |
| SECONDARY BATTERY (1) VEHICLE (V1) | 90% | 0.10 | 0.40 | 0.30 | 0.20 | 0.02 |
| SECONDARY BATTERY (2) VEHICLE (V2) | 85% | 0.08 | 0.30 | 0.24 | 0.15 | 0.01 |
| SECONDARY BATTERY (3) VEHICLE (V3) | 88% | 0.12 | 0.36 | 0.32 | 0.22 | 0.01 |
| SECONDARY BATTERY (4) VEHICLE (V4) | 80% | 0.05 | 0.30 | 0.20 | 0.10 | 0.00 |
| SECONDARY BATTERY (5) VEHICLE (V5) | 82% | 0.06 | 0.25 | 0.22 | 0.12 | 0.00 |
| PROFIT | — | +¥8000 | +¥18000 | +¥12000 | +¥15000 | — |

EP 4 300 758 B1

## FIG. 13

| TARGET BATTERY | SOH | PREDICTED BATTERY LOAD | | | | | |
|---|---|---|---|---|---|---|---|
| | | ROUTE (1) | ROUTE (2) | ROUTE (3) | ROUTE (4) | IDLE | POWER SELLING |
| SECONDARY BATTERY (1) VEHICLE (V1) | 90% | 0. 10 | 0. 40 | 0. 30 | 0. 20 | 0. 02 | 0. 12 |
| SECONDARY BATTERY (2) VEHICLE (V2) | 85% | 0. 08 | 0. 30 | 0. 24 | 0. 15 | 0. 01 | 0. 10 |
| SECONDARY BATTERY (3) VEHICLE (V3) | 88% | 0. 12 | 0. 36 | 0. 32 | 0. 22 | 0. 01 | 0. 12 |
| SECONDARY BATTERY (4) VEHICLE (V4) | 80% | 0. 05 | 0. 30 | 0. 20 | 0. 10 | 0. 00 | 0. 08 |
| SECONDARY BATTERY (5) VEHICLE (V5) | 82% | 0. 06 | 0. 25 | 0. 22 | 0. 12 | 0. 00 | 0. 07 |
| PROFIT | — | +¥8000 | +¥18000 | +¥12000 | +¥15000 | — | +¥1200 |

EP 4 300 758 B1

**EP 4 300 758 B1**

**REFERENCES CITED IN THE DESCRIPTION**

**Patent documents cited in the description**

- JP 2021029386 A
- US 2014320144 A1
- JP 5259443 B